(19) Europäisches Patentamt / European Patent Office / Office européen des brevets

(11) **EP 2 169 724 B1**

(12) **EUROPEAN PATENT SPECIFICATION**

(45) Date of publication and mention
of the grant of the patent:
**19.12.2018 Bulletin 2018/51**

(21) Application number: **08777083.0**

(22) Date of filing: **02.06.2008**

(51) Int Cl.:
**H01L 31/04** *(2014.01)*          **H01L 31/0463** *(2014.01)*

(86) International application number:
**PCT/JP2008/060132**

(87) International publication number:
**WO 2008/149835 (11.12.2008 Gazette 2008/50)**

(54) **INTEGRATED THIN FILM SOLAR CELL AND METHOD FOR FABRICATING THE SAME**

INTEGRIERTE DÜNNSCHICHTSOLARZELLE UND VERFAHREN ZU IHRER HERSTELLUNG

CELLULE SOLAIRE À COUCHE MINCE INTÉGRÉE ET SON PROCÉDÉ DE FABRICATION

(84) Designated Contracting States:
**AT BE BG CH CY CZ DE DK EE ES FI FR GB GR
HR HU IE IS IT LI LT LU LV MC MT NL NO PL PT
RO SE SI SK TR**

(30) Priority: **04.06.2007   JP 2007148366
25.06.2007   JP 2007166664**

(43) Date of publication of application:
**31.03.2010   Bulletin 2010/13**

(73) Proprietor: **Kaneka Corporation
Osaka (JP)**

(72) Inventor: **SASAKI, Toshiaki
Otsu-shi
Shiga 520-0104 (JP)**

(74) Representative: **Vossius & Partner
Patentanwälte Rechtsanwälte mbB
Siebertstrasse 3
81675 München (DE)**

(56) References cited:
**JP-A- 07 211 928          JP-A- 2001 267 613
JP-A- 2001 274 446          JP-A- 2002 016 269
JP-A- 2002 016 269          JP-A- 2002 141 526
JP-A- 2002 231 979          JP-A- 2006 054 254
JP-A- 2007 005 345          US-B1- 6 168 968**

**Description**

TECHNICAL FIELD

The present invention relates to a method for fabricating an integrated type thin film solar cell, and particularly to the improvement of a separation groove for integrating the solar cell and a method for forming the separation groove.

BACKGROUND ART

A solar cell has been spotlighted as one of earth-friendly energy sources, and rapidly popularized by a growing concern for environmental issues in recent years and introduction acceleration policies of some countries. Then, in order to cope with both lower cost and higher efficiency of a solar cell, a thin film solar cell capable of being fabricated from few raw materials has been noted and vigorously developed. In particular, a method for forming a high quality semiconductor layer on an inexpensive substrate such as glass in a low-temperature process has been expected as a method for realizing lower cost of a solar cell.

In the case of fabricating a large-area thin film solar cell for electric power capable of generating high output at a high voltage, a plurality of thin film solar cells formed on a substrate are not used while connected in series by wiring, but in order to improve a yield, a thin film solar cell formed on a large substrate is divided into a plurality of photoelectric conversion cells by patterning and the cells are generally integrated while connected in series. In particular, in a thin film solar cell receiving light from the glass substrate side, in order to reduce loss of a transparent conductive oxide (TCO) electrode layer on the glass substrate due to electric resistance, the transparent electrode layer is divided into a plurality of rectangular regions by laser scribing and each of the cells is generally integrated while connected in series in the direction straight to the longer direction of the rectangular regions.

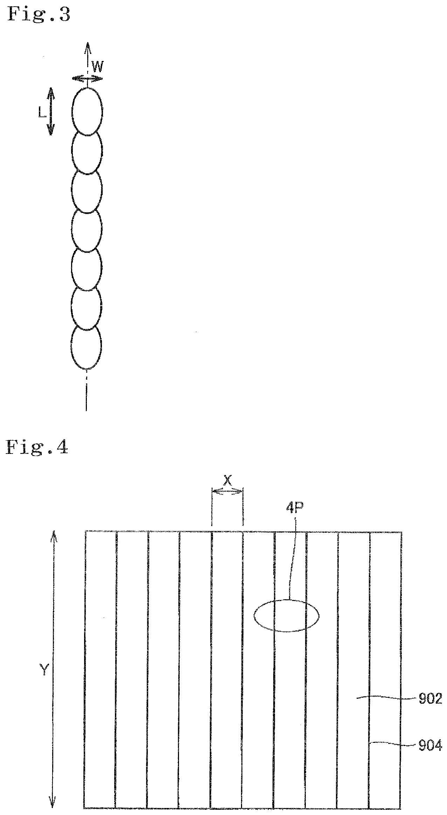

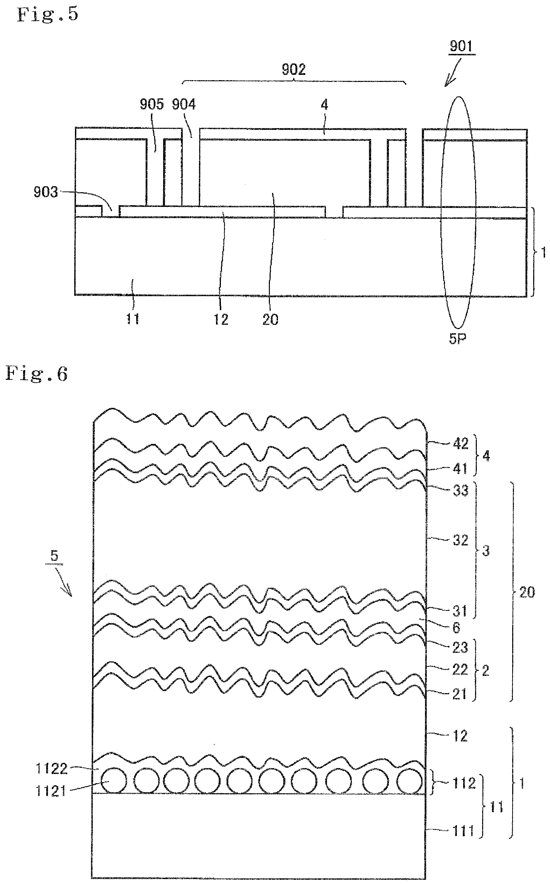

Fig. 4 shows a conceptual plan view of one example of such an integrated type thin film solar cell, and Fig. 5 shows a schematic cross-sectional view of one example of the multilayer structure of the region surrounded with an ellipse 4P in Fig. 4. In addition, Fig. 6 shows a schematic cross-sectional view of one further detailed example of the multilayer structure of the region surrounded with an ellipse 5P in Fig. 5. In the figures of the present application, dimension relation such as a length, a width and a thickness is properly modified for clarification and simplification of the figures, and does not denote the actual dimension relation. In the figures of the present application, the same reference numerals denote the same portions and the corresponding portions.

In the fabrication of an integrated type thin film solar cell as illustrated in Figs. 4 and 5, a glass substrate is 11. For example, an $SnO_2$ film having a thickness of 700 nm is formed as a transparent electrode layer 12 on the glass substrate by a thermal CVD (chemical vapor deposition) method. The transparent electrode layer 12 is separated into a plurality of rectangular transparent electrodes, each of which has a width X of approximately 10 mm, by transparent electrode separation grooves 903 with a width of approximately 100 $\mu$m formed by laser scribing. A residue after scribing is removed by ultrasonic cleaning with the use of water or an organic solvent. With regard to a cleaning method, the residue may be removed by using adhesive or gas jet.

A semiconductor layer 20 including amorphous photoelectric conversion unit and/or crystalline photoelectric conversion unit of 1 or more is formed on the transparent electrode layer 12. This semiconductor layer 20 is divided into a plurality of rectangular semiconductor regions by a semiconductor layer separation grooves 905 formed by laser scribing. The semiconductor layer separation groove 905 is utilized for electrically connecting the transparent electrode 12 and a back face electrode 4 between adjacent cells 902, so that it does not matter even though a residue of scribing remains partially in the groove and ultrasonic cleaning may be omitted. When the back face electrode layer 4 is subsequently formed, the semiconductor layer separation grooves 905 are embedded with metallic material for the back face electrode layer 4, and the back face electrode 4 of one cell and the transparent electrode 12 of the other cell are electrically connected in series between the adjacent photoelectric conversion cells 902 through the semiconductor layer separation groove 905.

The back face electrode layer 4 is patterned by the same laser scribing as the case of the semiconductor layer 20. That is, the back face electrode layer 4 is locally blown off with the semiconductor layer 20 by laser beam, so that a plurality of back face electrode layer separation grooves 904 are formed to thereafter perform ultrasonic cleaning. Thus, a plurality of the rectangular photoelectric conversion cells 902 are formed and electrically connected to each other in series through the semiconductor layer separation grooves 905. Lastly, the back sides of thin film solar cells are protected by a sealing resin (not shown in the figure).

YAG (yttrium·aluminum·garnet) laser light is generally subjected to pulse irradiation for laser scribing. In that case, the fundamental wave (a wavelength of 1064 nm) of the YAG laser is utilized for laser scribing of the transparent electrode layer separation groove 903, and the second harmonic (a wavelength of 532 nm) of the YAG laser is utilized for laser scribing of the semiconductor layer separation groove 905 and the back face electrode layer separation groove 904. The separation groove composed of a pit row, such that pits in approximately the same shape range at a predetermined pitch, is formed by subjecting laser light to pulse irradiation while relatively moving a laser beam irradiation spot and the substrate.

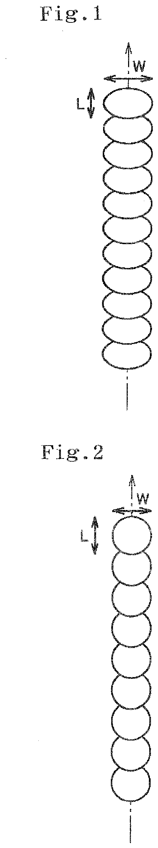

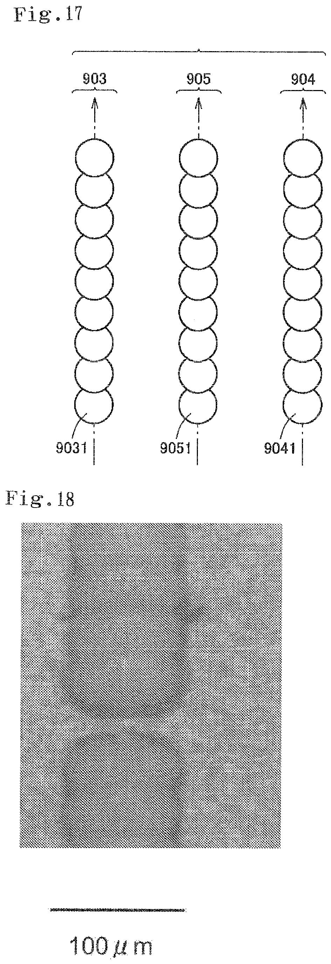

That is, as shown in a schematic plan view of Fig. 17, the transparent electrode layer separation groove 903, the semiconductor layer separation groove 905 and the back face electrode layer separation groove 904 are generally formed by a range of each of pits 9031, 9051 and 9041 in approximately the same shape. Each of these pits in approximately the same shape generally has a circular plane shape as shown in a schematic plan view of Fig. 2. However, as shown in a schematic plan view of Fig. 3, a pit row having an elliptic plane shape with the major axis along the longer direction of the separation groove is disclosed in Japanese Unexamined Patent Publication No. 2002-33495 which is referred as Patent Document 1 below.

In the formation process of the transparent electrode layer separation groove, a laser beam of infrared light (such as a wavelength of 1064 nm) with a high absorption coefficient in the transparent electrode layer is irradiated, so that the transparent electrode layer absorbs the laser beam to raise a temperature thereof, and then the transparent electrode layer evaporates to form the transparent electrode layer separation groove.

In the formation process of the semiconductor layer separation groove, a laser beam of visible light (such as a wavelength of 532 nm) with a low absorption coefficient in the transparent electrode layer and a high absorption coefficient in the semiconductor layer is irradiated, so that the semiconductor layer mainly absorbs the laser beam to raise a temperature thereof, and then the semiconductor layer evaporates to form the semiconductor layer separation groove.

In the formation process of the back face electrode layer separation groove, a laser beam of visible light transmitting through the transparent insulating substrate is irradiated, so that the semiconductor layer mainly absorbs the laser beam to raise a temperature thereof, and then the back face electrode layer is also blown off with vapor caused by the evaporated semiconductor layer to form the back face electrode layer separation groove.

In general, a photoelectric conversion efficiency (Eff) of a large-area integrated type thin film solar cell becomes lower than Eff of a small-area thin film solar cell including no integrated structure. The cause of a reduction in Eff is divided into the reason based on area difference and the reason based on the presence or absence of the integrated structure.

The cause that Eff lowers in the case where the area of a thin film solar cell is large is conceived to be a decrease in uniformity of a film quality and a film thickness of each of the transparent electrode layer, the semiconductor layer and the back face electrode layer, and an increase in probability of including a defect such as a pin hole.

On the other hand, the cause that Eff lowers in the case of including integrated structure is conceived to be such that the occurrence of an increase in leak current and a short circuit resulting from the transparent electrode layer separation groove and the back face electrode layer separation groove causes a decrease in an open circuit voltage (Voc) and a decrease in a fill factor (FF) to lower Eff. Also, an increase in series resistance resulting from the semiconductor layer separation grooves and the back face electrode layer separation grooves may decrease FF to lower Eff. In addition, the loss of an effective generating area due to the formation of the separation grooves may decrease a short-circuit current density (Jsc) to lower Eff.

Transparent conductive oxides (TCO) such as $SnO_2$ and ZnO are used for the transparent electrode layer 12 as shown in Fig. 5, and generally formed by methods such as CVD, sputtering and vacuum deposition. It is preferable that the transparent electrode layer 12 has so minute roughness on the surface thereof as to have the effect of increasing scattering of an incident light.

The semiconductor layer 20 includes at least one photoelectric conversion unit and one of the units includes pn junction or pin junction. Amorphous silicon, crystalline silicon, $CuInSe_2$ (abbreviated as CIS) and CdTe may be used for the semiconductor layer. In the specification of the application, terms of "crystalline" and "microcrystalline" also signify materials containing amorphous partially.

In the case of a silicon based thin film solar cell, a photoelectric conversion unit includes pin junction formed out of a p-type layer, an i-type photoelectric conversion layer, which is substantially intrinsic, and an n-type layer. Then, a unit including an i-type photoelectric conversion layer of amorphous silicon is referred to as an amorphous silicon photoelectric conversion unit, and a unit including an i-type photoelectric conversion layer of crystalline silicon is referred to as a crystalline silicon photoelectric conversion unit. Materials containing silicon only as the main element as well as alloy materials containing elements also such as carbon, oxygen, nitrogen and germanium may be used as amorphous or crystalline silicon based materials. A conductive layer does not necessarily need to be formed out of semiconductor materials of the same quality as the i-type layer. For example, in the case where the i-type layer is amorphous silicon, amorphous silicon carbide may be used for the p-type layer, and a microcrystalline-containing silicon layer (also called μc-Si layer) may be used for the n-type layer.

A metal layer such as Al and Ag may be formed as the back face electrode layer 4 formed on the semiconductor layer 20 by a sputtering method or a vacuum deposition method. As shown in Fig. 6, a conductive oxide layer 41 such as ITO (indium-tin oxide), $SnO_2$ and ZnO may be formed between the semiconductor layer 20 and a metal layer 42 included in the back face electrode layer 4.

In an amorphous silicon thin film solar cell, the initial photoelectric conversion efficiency is low as compared with a bulk monocrystalline or polycrystalline solar cell, which causes a problem such that the conversion efficiency lowers by photodegradation phenomenon (Staebler-Wronsky effect). Then, a crystalline silicon thin film solar cell, such that a crystalline silicon thin film including polycrystalline and microcrystalline is utilized for a photoelectric conversion layer, has been expected and studied as a solar cell capable of coping with both lower cost and higher efficiency. The reason therefor is that a crystalline silicon thin film solar cell may be fabricated at a comparatively low temperature by a plasma enhanced CVD method similarly to an amorphous silicon thin film solar cell, and photodegradation phenomenon is scarcely caused. A crystalline silicon photoelectric conversion layer may photoelectrically convert light with a wavelength of up to approximately 1200 nm on the long-wavelength side, which is longer than that of an amorphous silicon photoelectric conversion layer which may photoelectrically convert light with a wavelength of up to approximately 800 nm on the long-wavelength side.

In addition, a stacked thin film solar cell including 2 or more stacked photoelectric conversion units has been known as a method for improving the conversion efficiency of a thin film solar cell. In this stacked thin film solar cell, a front unit including a photoelectric conversion layer having a large energy bandgap is disposed on the light incident side, and a back unit including a photoelectric conversion layer having a small energy bandgap is sequentially disposed therebehind. This allows photoelectric conversion of incident light over a wide wavelength range, and intends the improvement of the conversion efficiency for the whole stacked thin film solar cell. Among stacked thin film solar cells, a thin film solar cell obtained by stacking an amorphous photoelectric conversion unit and a crystalline photoelectric conversion unit is referred to as a hybrid thin film solar cell.

Incidentally, with regard to a thin film solar cell, a photoelectric conversion layer may be thinned as compared with a solar cell adopting conventional bulk monocrystalline silicon or polycrystalline silicon, while the problem is that light absorption of the whole thin film is limited because of a film thickness. Then, in order to utilize incident light into the semiconductor layer more effectively, a contrivance is made such that the surface of the transparent electrode layer or the back face electrode layer contacting with the semiconductor layer is roughened (textured), and light is scattered on the interface to lengthen an optical path length in the semiconductor layer and then increase a light absorption amount in a photoelectric conversion layer. This technique is called "optical confinement" and becomes an important elemental technique in putting a thin film solar cell having high photoelectric conversion efficiency to a practical use.

An index for quantitatively denoting the roughened shape is necessary for obtaining the optimum surface roughened shape of the transparent electrode layer for a thin film solar cell. A haze ratio and a surface area ratio (Sdr) have been known as an index for denoting such a surface roughened shape.

The haze ratio is an index for optically evaluating the surface roughness of a transparent substrate and is represented by (diffuse transmittance/total light transmittance)$\times$100[%] (JIS K7136) . Such a haze ratio may be automatically measured by a commercial haze meter. The C light source is generally used as a light source for measuring it.

The surface area ratio is an index for denoting height difference of the surface roughness as well as a shape of the roughness. The surface area ratio is effective as an index for the surface roughness of a transparent conductive film in a thin film solar cell for the reason that the sharpening of the surface roughness of a transparent conductive film occasionally decreases an open circuit voltage and a fill factor of a thin film solar cell. The Surface area ratio is also called Developed Surface Area Ratio and Sdr is used as an abbreviation thereof.

A thin film solar cell is formed on a transparent insulting substrate such as glass, and a tin oxide ($SnO_2$) film having the surface roughness is frequently used as the transparent electrode layer. This surface roughness of the transparent electrode layer contributes to optical confinement into a photoelectric conversion layer. Accordingly, the increase of the surface roughness is desirable for improving the optical confinement effect; however, it is not easy that an $SnO_2$ film singly emphasizes the surface roughened shape while maintaining transparency and electrical conductivity necessary for a solar cell.

A glass base material having an $SnO_2$ film formed by a normal pressure thermal CVD method as the transparent electrode layer having the surface roughness effective for optical confinement needs a process at a comparatively high temperature of approximately 550 to 650°C for forming the transparent electrode layer, so that the fabricating cost ries. Then, the CVD temperature is so high that inexpensive substrates such as ordinary glass and plastic films may not be used. The exposure of tempered glass to the high-temperature process causes the effect of reinforcing to disappear, so that tempered glass may not be used for the base material and a thickness thereof needs to be increased for securing the strength of the glass base material in a large-area solar cell; consequently, the solar cell becomes heavier.

In addition, an $SnO_2$ film is so low in plasma resistance as to be possibly reduced under a deposition environment of the semiconductor layer through the utilization of high-density plasma containing hydrogen. An $SnO_2$ film is reduced and then blackened and lowered in transparency. That is to say, the blackened $SnO_2$ electrode layer absorbs incident light to decrease a transmitted light amount into the photoelectric conversion layer and cause a decrease in the conversion efficiency of a thin film solar cell. In particular, in the case of fabricating a hybrid thin film solar cell, a high plasma density is necessary during the deposition of a crystalline silicon layer as compared with the deposition of an amorphous silicon layer, and the conversion efficiency is vastly improved with difficulty in the case of using an $SnO_2$ film for the transparent electrode layer.

The transparent electrode layer may be desirably formed at low temperature for reducing the cost of a thin film solar cell. In particular, the transparent electrode layer needs to be formed at a temperature of 200°C or less for using tempered glass for the glass base material. Examples of a method for forming the transparent electrode layer at a low temperature of 200°C or less include deposition of ITO, ZnO or SnO$_2$ by a sputtering method, deposition of ITO or ZnO by an ion plating method, deposition of ITO or ZnO by a sol-gel method, and deposition of ZnO by a low-pressure thermal CVD method.

With regard to the transparent electrode layer formable at low temperature, zinc oxide (ZnO) is more inexpensive than SnO$_2$ or ITO widely used as materials for the transparent electrode layer, has the merit of being high in resistance to plasma, and is appropriate as a transparent electrode material for a thin film solar cell. In particular, a zinc oxide layer is preferable as the transparent electrode layer of a crystalline silicon thin film solar cell or a hybrid thin film solar cell including a crystalline silicon layer, which requires high-density plasma containing a large amount of hydrogen in depositing as compared with an amorphous silicon layer.

With regard to an integrated type thin film solar cell such that a transparent electrode layer, an amorphous semiconductor layer and a back face electrode layer are sequentially deposited on a transparent substrate, a method for shortening time for forming a separation groove by laser scribing to reduce the fabricating cost is disclosed in Patent Document 1. In this method, a plane shape of each pit in approximately the same shape, ranging at a predetermined pitch in a back face electrode layer separation groove formed by laser scribing, is made into an ellipse with the major axis in the longer direction of the separation groove, and a processing length per pulse of a laser beam is lengthened to improve a processing rate. Fig. 3 shows a schematic plan view of the separation groove according to this Patent Document 1. With regard to specific materials in an integrated type thin film solar cell of Patent Document 1, tin oxide (SnO$_2$), amorphous silicon and a metal film are used as the transparent electrode layer, the semiconductor layer and the back face electrode layer, respectively.

Incidentally, for the purpose of minimizing a decrease in the conversion efficiency in accordance with the integration of a thin film solar cell having a relatively large area, Japanese Unexamined Patent Publication No. 2001-274446 referred as Patent Document 2 discloses a method for fabricating an integrated type thin film solar cell such that a transparent electrode layer, a semiconductor layer, including an amorphous photoelectric conversion unit of 1 or more and a crystalline photoelectric conversion unit of 1 or more, and a back face electrode layer are sequentially stacked on a transparent insulating substrate. In this Patent Document 2, a heat-affected zone on a sidewall of the predetermined side in a back face electrode layer separation groove formed by the irradiation of a first laser beam is removed by the irradiation of a second laser beam having lower power than the first laser beam, whereby the prevention of the occurrence of leak current and a short circuit is intended.

Patent Document 1: Japanese Unexamined Patent Publication No. 2002-33495
Patent Document 2: Japanese Unexamined Patent Publication No. 2001-274446

DISCLOSURE OF THE INVENTION

PROBLEMS TO BE SOLVED BY THE INVENTION

As described above, in Patent Document 1, tin oxide is used for the transparent electrode layer of an integrated type thin film solar cell. However, an SnO$_2$ layer is high in the forming cost thereof as compared with a ZnO layer as the transparent electrode layer formable at low temperature, for example. An SnO$_2$ layer is formed in a process at a comparatively high temperature, and thus, an inexpensive substrate can not be used. An SnO$_2$ layer is so low in resistance to plasma as to tend to be blackened under a deposition environment of the photoelectric conversion layer by high-density plasma containing hydrogen. In addition, it is not easy to make a surface roughened shape of an SnO$_2$ layer markedly while maintaining transparency and electrical conductivity thereof.

From the above viewpoint, the inventors of the present invention have attempted to use not SnO$_2$ for the transparent electrode layer in Patent Document 1 but ZnO for the transparent electrode layer formable at low temperature, for example. As a result, in forming a pit of the back face electrode layer separation groove by a laser beam pulse, a problem has been found out such that too strong laser energy causes a discolored part in dark color in a pit. In the case where the back face electrode layer separation groove is formed by a laser beam pulse while ranging an elliptic pit in the major axis direction, it has been found out that an open circuit voltage (Voc), a fill factor (FF) and a photoelectric conversion efficiency (Eff) of an integrated type thin film solar cell are decreased, and a yield of an integrated type thin film solar cell is also decreased.

In addition, as described about the above-mentioned background art, in an integrated type thin film solar cell, the problem is that a photoelectric conversion efficiency (Eff) tends to be generally decreased as compared with a thin film solar cell including no integrated structure.

Then, as in Patent Document 2, the inventors of the present invention have attempted to fabricate an integrated hybrid thin film solar cell in such a process that the back face electrode layer separation groove is formed by a first laser beam and subsequently a sidewall of the predetermined side in the back face electrode layer separation groove formed by the first laser beam is removed by a second laser beam having relatively low energy density. As a result, unlike the description of Patent Document 2, a problem has been found out such that Eff is decreased as compared with the case of not utilizing the second laser beam. More specifically, with regard to an integrated hybrid thin film solar cell in which 50 rows of photoelectric conversion cells are integrated, in the case where all of the back face electrode layer separation grooves are formed by using the first and the second laser beams as the method of Patent Document 2, a problem has been found out such that FF is reduced and Eff is decreased as compared with the case of being formed by using the first laser beam only.

Then, the present invention is intended to improve a photoelectric conversion efficiency, cost and yield of an integrated type thin film solar cell including the transparent electrode layer formable at low temperature.

MEANS FOR SOLVING THE PROBLEM

The present invention is defined by the method of claim 1. A discolored part in dark color in the pits may be caused by becoming convex as compared with a peripheral portion thereof.

W/L is preferably within the range from 1.25 or more to 7.2 or less. The maximum length d by which adjacent pits overlap in a longer direction of the grooves is preferably within the range from 6% or more to 33% or less of L. More specifically, the plane shape of each of the pits may be elliptic. The plane area of each of the pits is preferably within the range from $3 \times 10^{-10}$ m2 or more to $4 \times 10^{-8}$ m2 or less.

Another embodiment of a method for fabricating the integrated type thin film solar cell as described above is characterized by including a step of irradiating a first laser beam on the whole region for forming a plurality of back face electrode layer separation grooves, and a step of additionally irradiating a second laser beam on at least one part of each of the grooves of a partial number selected from all of the back face electrode layer separation grooves, wherein the center of an irradiated region N is displaced from the center of an irradiated region M in a direction moving away from the nearest semiconductor layer separation groove thereto so that the irradiated region N of the second laser beam overlaps partially with the irradiated region M of the first laser beam.

In the back face electrode layer separation grooves, the ratio of a local maximum value of a groove width in a portion formed by additionally irradiating the second laser beam to a local maximum value of a groove width in a portion formed by only irradiating the first laser beam is preferably within the range from 1.15 or more to 1.8 or less. The energy density of the second laser beam is preferably low as compared with the first laser beam. The first and the second laser beams are irradiated in a pulsed laser, and the number of irradiated pulses of the second laser beam is preferably large as compared with the first laser beam with regard to a unit length of the back face electrode layer separation grooves.

Another embodiment of a method for fabricating an integrated type thin film solar cell of the present invention is characterized in that at least one part of each groove of a partial number among a plurality of back face electrode layer separation is composed of a row of first kind pits in substantially the same shape ranging at a first pitch and a row of second kind pits in substantially the same shape ranging at a second pitch, that the row of first kind pits and the row of second kind pits overlap partially in a groove width direction, that a local maximum length Wn of the row of second kind pits in a groove width direction is small as compared with a local maximum length Wm of the row of first kind pits in a groove width direction, and that a center line of the row of second kind pits is displaced from a center line of the row of first kind pits in a direction moving away from the nearest semiconductor layer separation groove thereto.

The ratio Wo/Wm of a local maximum length Wo of a groove width composed of both the row of first kind pits and the row of second kind pits to a local maximum length Wm of the row of first kind pits in a groove width direction is preferably 1.15 or more and 1.8 or less. The second pitch of the row of second kind pits is preferably short as compared with the first pitch of the row of first kind pits.

EFFECT OF THE INVENTION

According to the present invention as described above, in each of a range of pits composing at least one part of the separation grooves, a maximum length W in a groove width direction is determined more largely than a maximum length L in a groove longer direction, so that Voc, FF and Eff of an integrated type thin film solar cell including the transparent electrode layer formable at low temperature can be improved to improve the fabricating cost by improving a yield.

According to an embodiment of the present invention, an additional second laser beam may be selectively irradiated on defective portions with leak current or a short circuit caused among back face electrode layer separation grooves formed by irradiating a first laser beam to remove the defective portions, so that Voc, FF and Eff of an integrated type thin film solar cell can be improved to improve the fabricating cost by improving a yield.

BRIEF DESCRIPTION OF THE DRAWINGS

Fig. 1 is a schematic plan view showing one example of a pit row formed by a laser beam pulse in the present invention.

Fig. 2 is a schematic plan view showing one example of a pit row formed by a laser beam pulse conventionally used in common.

Fig. 3 is a schematic plan view showing one example of a pit row formed by a laser beam pulse according to Patent Document 1.

Fig. 4 is a conceptual plan view showing one example of an integrated type thin film solar cell.

Fig. 5 is a schematic cross-sectional view showing one example of stacked structure in a region shown by an ellipse 4P in Fig. 4.

Fig. 6 is a schematic cross-sectional view showing in further detail one example of stacked structure in a region shown by an ellipse 5P in Fig. 5.

Fig. 7 is a schematic cross-sectional view for describing damage occurrence of a transparent electrode layer in a thin film solar cell according to prior art.

Fig. 8 is an optical microphotograph showing a region of separation grooves formed by a laser beam pulse in one example of the present invention.

Fig. 9 is an optical microphotograph showing another region of the same separation grooves as Fig. 8.

Fig. 10 is an optical microphotograph showing a region of separation grooves formed by a conventional laser beam pulse.

Fig. 11 is a graph showing the relation of a photoelectric conversion efficiency Eff to a ratio W/L of a maximum length W in a groove width direction to a maximum length L in a groove longer direction of each pit composing back face electrode layer separation grooves, with regard to an integrated type thin film solar cell according to Examples 1 to 4 and Comparative Examples 1 to 4 of the present invention.

Fig. 12 is a graph showing the relation of a minimum width V of separation grooves to a ratio d/L of a maximum length d by which adjacent pits overlap in a groove longer direction to a maximum length L in a groove longer direction of pits.

Fig. 13 is a graph showing the influence of the ratio d/L on a ratio $\Sigma d/$ of the total $\Sigma d$ of overlap length of pits to the full length Y of separation grooves.

Fig. 14 is a schematic plan view showing forms of transparent electrode layer separation grooves, semiconductor layer separation grooves, and back face electrode layer separation grooves in an integrated type thin film solar cell according to one embodiment of the present invention.

Fig. 15 is a schematic cross-sectional view showing an integrated type thin film solar cell according to one embodiment of the present invention.

Fig. 16 is a schematic cross-sectional view showing an elliptic region 2Q in Fig. 15 while magnifying.

Fig. 17 is a schematic plan view showing forms of transparent electrode layer separation grooves, semiconductor layer separation grooves, and back face electrode layer separation grooves in a conventional and typical integrated type thin film solar cell.

Fig. 18 is an optical microphotograph showing one example of pit dislocation in back face electrode layer separation grooves formed by irradiating a first laser beam in an integrated type thin film solar cell.

Fig. 19 is an optical microphotograph showing a state such that pit dislocation in Fig. 18 is repaired by additional irradiation of a second laser beam.

Fig. 20 is a graph showing the relation between Wo/Wm and $\Delta$Vfl, which are parameters determined in the present invention, with regard to back face electrode layer separation grooves of an integrated type thin film solar cell.

Fig. 21 is a graph showing the relation between E2/E1 and $\Delta$Vfl, which are parameters determined in the present invention, with regard to back face electrode layer separation grooves of an integrated type thin film solar cell.

Fig. 22 is a graph showing the relation between P2/P1 and $\Delta$Vfl, which are parameters determined in the present invention, with regard to back face electrode layer separation grooves of an integrated type thin film solar cell.

Fig. 23 is an SEM photograph showing a cross section of a part of an integrated type thin film solar cell according to one example of the present invention.

Fig. 24 is an SEM photograph showing a cross section of a part of an integrated type thin film solar cell according to another example of the present invention.

Fig. 25 is a graph showing the relation between $Vfl_1$ and $(Vfl_2-Vf_1)$, which are parameters determined in the present invention, with regard to back face electrode layer separation grooves of an integrated type thin film solar cell.

Fig. 26 is an optical microphotograph showing the top face of a part of back face electrode layer separation grooves of an integrated type thin film solar cell including a ZnO transparent electrode layer.

Fig. 27 is an optical microphotograph showing the top face of a part of back face electrode layer separation grooves of an integrated type thin film solar cell including an $SnO_2$ transparent electrode layer.

REFERENCE NUMERALS

1 thin film solar cell substrate, 11 transparent insulating substrate, 111 transparent base material, 112 transparent foundation layer, 1121 transparent particle, 1122 transparent binder, 12 transparent electrode layer, 20 semiconductor layer, 2 front photoelectric conversion unit, 21 one conductive type layer, 22 photoelectric conversion layer, 23 opposite conductive type layer, 3 rear photoelectric conversion unit, 31 one conductive type layer, 32 photoelectric conversion layer, 33 opposite conductive type layer, 4 back face electrode layer, 41 conductive oxidation product layer, 42 metal layer, 5 stacked thin film solar cell, 6 intermediate transmission reflective layer, 901 integrated type thin film solar cell, 902 photoelectric conversion cell, 903 transparent electrode layer separation groove, 904 back face electrode layer separation groove, 905 semiconductor layer separation groove, 9031 pit, 9040 back face electrode layer separation groove, 9041 pit, 9043 first kind pit, 9044 first kind pit row, 9045 second kind pit, 9046 second kind pit row, 9051 pit

BEST MODE FOR CARRYING OUT THE INVENTION

As described above, the inventors of the present invention have attempted to use not an $SnO_2$ layer but a ZnO layer formable at low temperature for the transparent electrode layer in Patent Document 1. As a result, in the case where a plane shape of a pit has a maximum length L in a longer direction larger than a maximum length W in a width direction of the separation grooves, such as an ellipse having the major axis in a longer direction of the separation grooves, it has been found out that an open circuit voltage (Voc), a fill factor (FF) and a photoelectric conversion efficiency (Eff) of an integrated solar cell are decreased, and a yield of an integrated type thin film solar cell is also decreased.

Then, when the case of forming the separation grooves by a laser beam was studied for fabricating an integrated type thin film solar cell including the transparent electrode layer formable at low temperature, it has been found that the separation grooves is hardly formed in the transparent electrode layer formable at low temperature as compared with an $SnO_2$ layer, and Eff is decreased by a decrease in FF due to an increase in series resistance and a decrease in Voc and FF due to an increase in an electrical short circuit or leak current. Also, it has been found that the back face electrode layer separation grooves are particularly formed with the greatest difficulty among the transparent electrode layer separation grooves, the semiconductor layer separation grooves, and the back face electrode layer separation grooves.

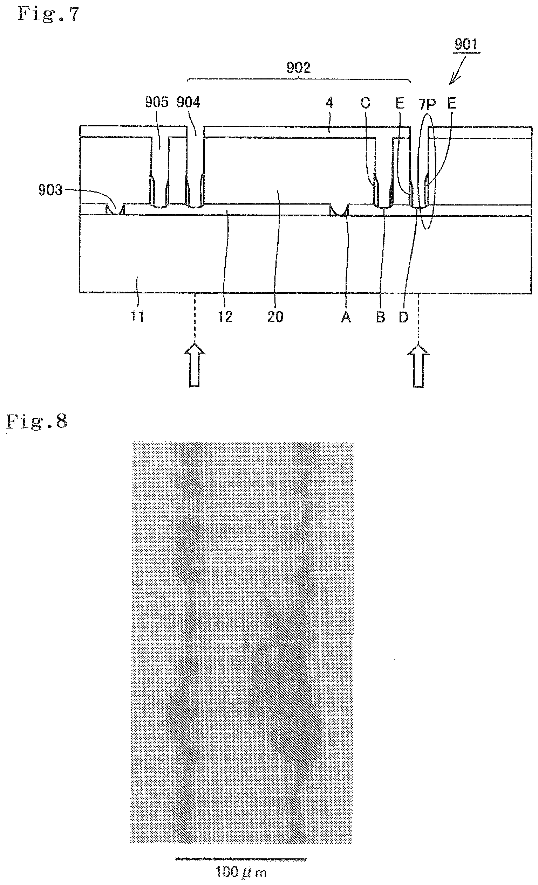

The reason therefor is not necessarily clear and may be explained by a model as shown in a schematic cross-sectional view of Fig. 7. First, a ZnO layer has the advantage of being formable at low temperature as compared with an $SnO_2$ layer, while a ZnO layer is vaporized at low temperature so easily as to tend to be damaged in forming the separation grooves.

In forming the transparent electrode layer separation grooves 903, the ZnO layer 12 is not merely vaporized and removed in a position on which a laser beam is irradiated, but also the heat propagates to the periphery thereof, and the melted ZnO resolidifies and may remain as a residue A on the bottom face and a sidewall of the transparent electrode separation grooves 903. It is conceived that this residue A may cause an increase in leak current and an electrical short circuit.

Also, in forming the semiconductor layer separation grooves 905, the semiconductor layer 20 is not merely vaporized and removed in a position on which a laser beam is irradiated, but also the ZnO layer 12 thereunder is partially vaporized into a thin portion B, and it is conceived that the resistance is increased in this portion. However, the semiconductor layer separation grooves 905 are utilized for electrically connecting the transparent electrode 12 and the back face electrode 4 between adjacent cells, so that it does not matter even though a residue C of ZnO remains partially in the semiconductor layer separation grooves 905.

In addition, in forming the back face electrode layer separation grooves 904, the ZnO layer 12 is partially vaporized into a thin portion D similarly to the case of forming the semiconductor layer separation grooves 905, so that the resistance in the portion is not merely increased but also the vaporized ZnO may remain as a residue E on the bottom face and a sidewall of the back face electrode layer separation grooves 904. It is conceived that this residue E may cause an increase in leak current and an electrical short circuit. In particular, as shown in an ellipse 7P in Fig. 7, the residue E on the right sidewall of the back face electrode layer separation grooves may cause a notable increase in leak current and a short circuit.

Actually, in the case where the ZnO layer formed at a low temperature of 200°C or less was used for the transparent electrode layer and the case where the $SnO_2$ layer formed at a high temperature of 500°C or more was used for the transparent electrode layer, a different result was obtained in forming the back face electrode layer separation grooves while intentionally changing an energy density of a laser beam.

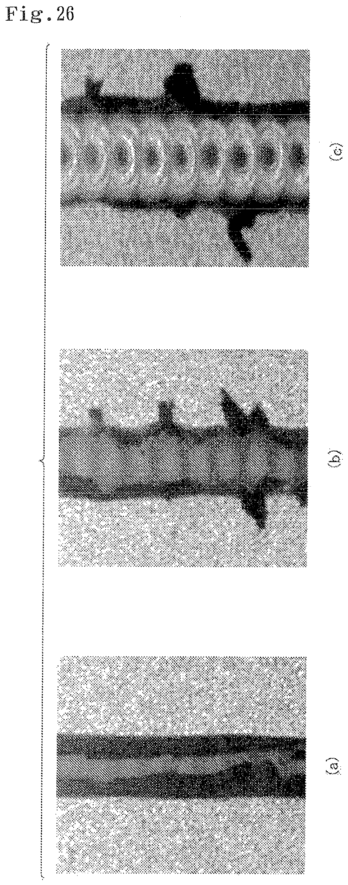

Fig. 26 is an optical microphotograph showing the top face of a part of the back face electrode layer separation grooves of an integrated type thin film solar cell including the ZnO transparent electrode layer. The minimum energy density of a laser beam capable of cutting the back face electrode layer is denoted as Emin, and Figs. 26 (a), (b) and (c) show optical microphotographs in the case of forming the back face electrode layer separation grooves at an energy density of each of 85%, 100% and 300% (three times) of Emin. These optical microphotographs were taken by irradiating white light into a pit from the back face electrode side with the use of a high-definition digital microscope Model VH-6300 manufactured by Keyence Corp. Needless to say, Model VHX-900 as an alternative type manufactured by Keyence Corp. as well as other optical microscopes such as a stereoscopic microscope may be used as an optical microscope.

In the case of Fig. 26 (a) in which an energy density of 85% of Emin is utilized, the back face electrode layer material is removed only in a bright portion with one third of the width of the middle of the groove width, and the back face electrode layer material remains on both sides of the groove width. Then, the back face electrode layer separation grooves remain uncut in more than half of the whole area thereof and thus the normal function of separating may not be performed.

In the case of Fig. 26 (b) in which an energy density of Emin is utilized, the back face electrode layer material remains in the groove region with some burrs, but the back face electrode layer material in the region with a laser beam irradiated is nearly removed to form the back face electrode layer separation grooves.

In the case of Fig. 26 (c) in which an energy density of three times of Emin is utilized, a discolored part in dark color is observed in the middle of the formed pit. This suggests that the use of a laser beam having three times of Emin in forming the back face electrode layer separation grooves causes the ZnO transparent electrode layer under the semiconductor layer to be damaged. In this case of Fig. 26 (c), as compared with the case of Fig. 26 (b), Voc and FF of an integrated type thin film solar cell were decreased to decrease Eff.

When the discolored part in dark color in the pit was observed by using a scanning laser microscope LEXTOLS3000 (presently, a succeeding type of LEXTOLS3100) manufactured by Olympus Corporation, it has proved that the discolored part in dark color is convex as compared with the periphery thereof. On the other hand, in the case of irradiating a laser beam having an energy density of Emin, he bottom face in the pit was nearly flat.

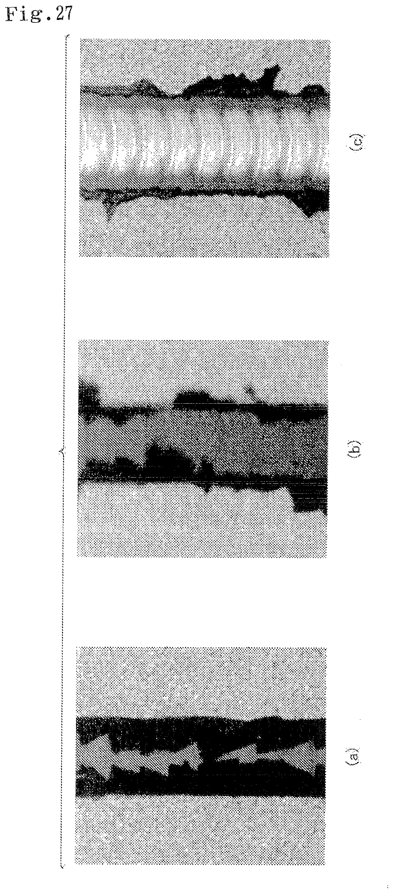

Fig. 27 is an optical microphotograph showing the top face of a part of the back face electrode layer separation grooves of an integrated type thin film solar cell using an $SnO_2$ transparent electrode layer. Similarly to the case of Figs. 26 (a), (b) and (c), Figs. 27 (a), (b) and (c) show optical microphotographs in the case of forming the back face electrode layer separation grooves at an energy density of each of 85%, 100% and 300% (three times) of Emin.

In the case of Fig. 27 (a) in which an energy density of 85% of Emin is utilized, the back face electrode layer material remains on both sides of the grooves. Then, the back face electrode layer separation grooves remain uncut in more than half of the whole area thereof and thus the normal function of separating may not be performed.

In the case of Fig. 27 (b) in which an energy density of Emin is utilized, the back face electrode layer material remains in the groove region with some burrs, but the back face electrode layer material in the region with a laser beam irradiated is nearly removed to form the back face electrode layer separation grooves.

In the case of Fig. 27 (c) in which an energy density of three times of Emin is utilized, with regard to the $SnO_2$ layer unlike the ZnO layer, a discolored part in dark color is not observed in the middle of the pit. That is to say, in the case of using the $SnO_2$ layer for the transparent electrode layer, even though an energy density of a laser beam is increased in forming the back face electrode layer separation grooves, it is suggested that the $SnO_2$ transparent electrode layer under the semiconductor layer is hardly damaged. When the pit in this case was also observed by a scanning laser microscope, it has been confirmed that the bottom face in the pit is nearly flat.

In Fig. 7, for clarification of the drawing, a dimension in the thickness direction is drawn while notably magnified with respect to a dimension of a length in the horizontal direction. However, actually, the thickness of the semiconductor layer 20 is within the range from several hundreds nm to several $\mu$m and the width of each of the separation grooves is within the range from several tens to several hundreds $\mu$m. That is to say, the thickness of the semiconductor layer 20 is a small dimension within the range from approximately 1/100 to 1/10 of the width of each of the separation grooves. The transparent electrode separation grooves 903 are controlled for leak current and a short circuit in the width direction thereof; however, the back face electrode layer separation grooves 904 needs to be controlled for leak current and a short circuit in the width direction as well as the depth direction thereof. That is to say, the back face electrode layer separation grooves 904 needs to prevent leak current and a short circuit in a short distance by 1 to 2 digits as compared with the transparent electrode separation grooves 903, and it is the most difficult to favorably form the back face electrode layer separation grooves 904 among three kinds of the separation grooves.

In order to avoid the damage of the ZnO layer as described above, when the inventors of the present invention further studied about the forming conditions of the separation grooves, it has been found that an energy density of a laser beam needs to be decreased as much as possible. However, a decrease in an energy density of a laser beam easily causes a defect due to an uncut portion of the separation grooves. Examples of kinds of the defect due to an uncut portion of the separation grooves include a defect such that burrs remain in the separation grooves, a defect such that the pit breaks partially (pit dislocation), and a defect such that the pit row curves partially (pit row curve) . The width of the separation grooves is the thinnest in a constricted portion between the adjacent pits, so that a defect due to an uncut portion is easily caused in this portion. In particular, in the back face electrode layer separation grooves 904, the slightest uncut portion of the back face electrode layer 4 causes a short circuit between the adjacent photoelectric conversion cells.

For example, when burrs of metal included in the back face electrode layer 4 exist across the back face electrode layer separation grooves 904, a short circuit is caused and Voc of the photoelectric conversion cell on the right side becomes 0 V.

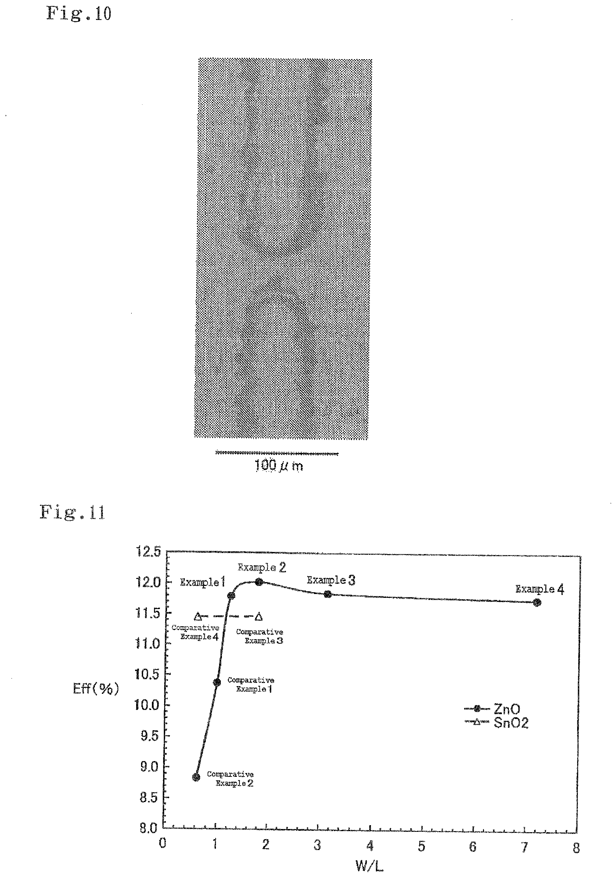

It is conceived that the pit dislocation is caused in the case where a laser beam does not reach a position of the separation grooves, resulting from a foreign matter attached to a glass substrate and a film or a foreign matter in a glass substrate. When an energy density of a laser beam is low, it is conceived that the presence of a slight foreign matter easily causes the pit dislocation. The optical microphotograph of Fig. 10 shows an example such that the separation grooves are interrupted by the pit dislocation.

It is conceived that when air bubbles exist in a glass substrate and irregularities of approximately the same size or more of the pit exist in a part of a glass substrate and a transparent film, they function as a concave lens and a convex lens, and a laser beam turns away from the design position to cause the pit row curve. When an energy density of a laser beam is low, it is conceived that the presence of slight irregularities easily causes the pit row curve.

In view of the above-mentioned situation, the inventors of the present invention have studied further earnestly about an integrated type thin film solar cell including the ZnO transparent electrode layer. As a result, it has been found out that a maximum length W in a groove width direction is set more largely than a maximum length L in a groove longer direction in each of the pits composing the separation grooves, so that an energy density of a laser beam may be decreased to reduce the damage of the ZnO layer and to reduce a defect due to an uncut portion of the separation grooves, and a conversion efficiency and a yield of an integrated type thin film solar cell can be improved.

As shown in a schematic plan view of Fig. 2, a circular shape is generally adopted as a plane shape of each of the pits composing the separation grooves. However, as shown in Fig. 3, a pit row having an elliptic plane shape with the major axis in a groove longer direction is disclosed in the above-mentioned Patent Document 1. On the other hand, setting a plane shape of the pits composing the separation grooves to a lateral shape extending in a groove width direction has not been performed conventionally for the reason that generating area loss of the photoelectric conversion cells is increased and the number of pits necessary per unit length of the separation grooves is increased to decrease a processing rate. However, in the present invention, setting a plane shape of the pits at a lateral shape within an industrially allowable range of generating area loss and a decrease in a processing rate has allowed a photoelectric conversion efficiency and cost of an integrated type thin film solar cell including the ZnO transparent electrode layer to be improved.

As described above, in accordance with the instructions of Patent Document 2, the inventors of the present invention have attempted to fabricate an integrated hybrid thin film solar cell by including a process such that the back face electrode layer separation grooves is formed by a first laser beam and subsequently a sidewall of the predetermined side in the back face electrode layer separation grooves formed by the first laser beam is removed by a second laser beam having relatively low power. As a result, unlike the description of Patent Document 2, a problem has been found out such that Eff is decreased as compared with the case of not utilizing the second laser beam.

Specifically, a problem has been found out such that the occurrence of an increase in leak current and a short circuit decreases Voc and FF to lower Eff, or an increase in series resistance (Rs) mainly decreases FF to lower Eff. Also, a problem has been found out such that a yield of an integrated type thin film solar cell is decreased.

In the method disclosed in Patent Document 2, the first laser beam irradiated region and the second laser beam irradiated region in forming the back face electrode layer separation grooves 904 are not the same, but overlap partially, so that is conceivede that the transparent electrode layer 12 is damaged in the overlap portion. Then, as a result, it is conceived that a thin portion D of the transparent electrode layer 12 is caused and a residue E is caused on the bottom face and a sidewall of the back face electrode layer separation grooves 904. Also, in Patent Document 2, in order to reduce the damage of the transparent electrode layer 12, an energy density of the second laser beam is decreased as compared with the first laser beam, and yet the probability that a thin portion D of the transparent electrode layer 12 is caused and a residue E is caused on the bottom face and a sidewall of the back face electrode layer separation grooves 904 is not zero.

Then, in order to reduce the occurrence of a thin portion D of the transparent electrode layer 12 and the occurrence of a residue E on the bottom face and a sidewall of the separation grooves 904 in forming the back face electrode layer separation grooves 904, the inventors of the present invention have studied about the irradiation conditions of a laser beam in further detail. As a result, it has been found that a conversion efficiency and a yield of an integrated type thin film solar cell can be improved by additionally irradiating the second laser beam on only grooves including a defect region for causing current leak and a short circuit or the defect region among the back face electrode layer separation grooves 904 formed by irradiating the first laser beam.

More specifically, the center of an irradiated region N is displaced from the center of an irradiated region M in a direction moving away from the nearest semiconductor layer separation grooves 905 thereto so that the irradiated region N of the second laser beam overlaps partially with the irradiated region M of the first laser beam in forming the back face electrode layer separation grooves 904, which makes it possible to solve current leak in a depth direction of the back face electrode layer separation grooves 904 and a defect due to an uncut portion of the grooves. In this case, it is conceived that the transparent electrode layer 12 is easily damaged in a local region on which the first laser beam and the second laser beam are irradiated with overlap. However, the first laser beam and the second laser beam are irradiated with overlap on only grooves including a defect region for causing current leak and a short circuit or the defect region among the back face electrode layer separation grooves 904, and the second laser beam is not irradiated on the back face electrode layer separation grooves 904 including no defect regions.

Accordingly, the advantage in removing a defect region is greater than the disadvantage due to the local damage of the transparent electrode layer 12 in the back face electrode layer separation grooves including a defect region, and consequently, a conversion efficiency and a yield of an integrated type thin film solar cell can be improved. That is to say, a conversion efficiency and a yield of an integrated type thin film solar cell can be improved by additionally irradiating the second laser beam on only the back face electrode layer separation grooves of the necessity minimum number or the defect region.

Herein, with regard to whether a defect region exists in a specific back face electrode layer separation groove 904 or not, the characteristics need to be inspected in each cell by using a curve tracer. Then, the additional second laser beam needs to be selectively irradiated on the back face electrode layer separation grooves determined to include a defect region or the defect region. That is to say, a region on which the second laser beam is irradiated in addition to the first laser beam varies with an integrated type thin film solar cell under fabrication, and the laser beam irradiation is controlled so complicatedly that those skilled in the art sensibly will not conceive such a method for fabricating.

However, as a result of the studies by the inventors of the present invention, even though the necessity of characteristic inspection of each cell and the complication of control of the laser beam irradiation are brought, an Eff and a yield of an integrated type thin film solar cell may be notably improved by additionally irradiating the second laser beam on only the back face electrode layer separation grooves 904 including a defect region or only the defect region, and it has proved that this advantage obtained by the method outweigh the disadvantage of the complication of processes.

On the basis of the detailed studies of the inventors of the present invention as described above, preferable embodiments of the present invention are described below while referring to figures.

An integrated type thin film solar cell may also be referred in Figs. 4 to 6. That is to say, an integrated type thin film solar cell is also provided with a thin film solar cell substrate 1 including a transparent insulating substrate 11 and a transparent electrode layer 12 formed thereon (refer to Figs. 5 and 6). A semiconductor layer 20 including a front photoelectric conversion unit 2, an intermediate transmission reflective layer 6 and a rear photoelectric conversion unit 3 deposited sequentially is formed on the substrate 1, and a back face electrode layer 4 is formed thereon.

Also, in an integrated type thin film solar cell, the transparent insulating substrate 11 includes a transparent base material 111 and a transparent foundation layer 112 as shown in Fig. 6. Tabular members or sheet members such as glass and a transparent resin may be used for the transparent base material 111. Since it is located on the light incident side of a thin film solar cell 5, the transparent insulating substrate 11 is preferably as transparent as possible in order that more sunlight may be transmitted through and be absorbed in the photoelectric conversion units 2 and 3. In particular, a glass substrate is desirable as the transparent base material 111 by reason of being high in transmittance and low in price. In view of similar intention, it is desirable that anti-reflection coating (not shown in figures) is performed for the light incidence plane of the transparent insulating substrate 11 so as to decrease light reflection loss in the light incidence plane of the thin film solar cell 5. The transparent insulating substrate 11 is usable even though composed of only the transparent base material 111 but more preferably includes the transparent base material 111 and the transparent foundation layer 112. The reason therefor is that the transparent foundation layer 112 allows the effect of improving adhesion properties of the transparent electrode layer and increasing surface concavity of the transparent electrode layer.

The transparent foundation layer 112 may be formed from coating solution including transparent particles 1121 with a binder material including a solvent. More specifically, metallic oxides such as silicon oxide, aluminum oxide, titanium oxide, zirconium oxide and tantalum oxide may be utilized as a transparent binder 1122. Silica ($SiO_2$), titanium oxide ($TiO_2$), aluminum oxide ($Al_2O_3$), zirconium oxide ($ZrO_2$), indium-tin oxide (ITO) or magnesium fluoride ($MgF_2$) may be used as the transparent particles 1121. A dipping method, a spin coat method, a bar coat method, a spray method, a die coat method, a roll coat method and a flow coat method may be utilized as a method for allowing the above-mentioned coating solution on the surface of the transparent base material 111, and the roll coat method may be appropriately used for distributing the transparent particles 1121 minutely and uniformly. The allowed coating solution film is immediately heated and dried. A shape of the particles is preferably globular for uniformly forming minute surface irregularities in the foundation layer 112.

A material for the transparent electrode layer is preferably a material such that the layer may be formed at a temperature of 200°C or less. When forming temperature of the transparent electrode layer is a temperature of 200°C or less, tempered glass may be used for the substrate and the thin film solar cell may be reduced in weight by thinning a glass substrate on the same strength conditions. Examples of a method for forming the transparent electrode layer at a low temperature of 200°C or less include deposition of ITO, ZnO or $SnO_2$ by a sputtering method, deposition of ITO or ZnO by an ion plating method, deposition of ITO or ZnO by a sol-gel method, and deposition of ZnO by a low-pressure thermal CVD method.

A material for the transparent electrode layer 12 disposed on the transparent insulating substrate 11 is ZnO. It is desirable that doping impurities thereof contain at least one kind of B, Al and Ga, and it is particularly desirable that a B atom is contained at a concentration of $2\times10^{19}/cm^3$ or more. The transparent electrode layer 12 preferably contains an H atom of $2\times10^{20}/cm^3$ or more in addition to doping impurities. The ZnO layer containing H is appropriate as the transparent electrode layer for the thin film solar cell for the reason that the surface roughness having an optical confinement effect may be formed also by low-pressure thermal CVD at a low substrate temperature of 200°C or less. The substrate temperature in the specification of the application signifies a temperature of a plane on which the substrate contacts with a heating unit of film formation equipment.

The ZnO layer is preferable by reason of being capable of being easily deposited at a low temperature of 200°C or less by a low-pressure thermal CVD method. The ZnO layer thus deposited may include preferable minute surface roughness. With regard to the specific deposition conditions of the ZnO layer, a mixed gas containing diethyl zinc (DEZ) or dimethyl zinc as organic metal vapor, water vapor as an oxidizer, $B_2H_6$ as a doping gas, and at least one kind of $H_2$, He and Ar as a diluting gas is preferably introduced into a low-pressure thermal CVD reaction chamber decompressed to a pressure of 5 to 200 Pa. The substrate temperature during film formation thereof is preferably 200°C or less, more preferably 140°C or more and 170°C or less. The flow rate of DEZ may be set to 10 to 1000 sccm, the flow rate of water vapor at 10 to 1000 sccm, the flow rate of $H_2$ at 100 to 10000 sccm, and the flow rate of Ar at 100 to 10000 sccm. $B_2H_6$ is preferably set to 0.1% to 10% with respect to DEZ.

It is preferable that ZnO crystalline grain diameter contained in the transparent electrode layer 12 is approximately 50 to 500 nm and height difference of the surface roughness is approximately 20 to 200 nm from the viewpoint of an optical confinement effect of the thin film solar cell. The haze ratio of the thin film solar cell substrate 1 is preferably 15% or more, more preferably 20% or more from the viewpoint of an optical confinement effect.

Sheet resistance of the ZnO electrode layer 12 is preferably 15 $\Omega/\square$ or less, more preferably 10 $\Omega/\square$ or less from the viewpoint of reducing resistance loss.

An average thickness of the ZnO electrode layer 12 is preferably 0.7 to 5 $\mu$m, more preferably 1 to 3 $\mu$m. The reason therefor is that too thin ZnO layer has difficulty in sufficiently allowing the surface roughness for contributing to an optical confinement effect, and necessary electrical conductivity as a transparent conductive film is hardly obtained. On the contrary, a too thick ZnO layer decreases a light amount for reaching the photoelectric conversion unit to decrease a conversion efficiency, resulting from light absorption by itself, and causes an increase in cost due to an increase in film formation time.

It is desirable that the surface area ratio (Sdr) of the ZnO electrode layer 12 is 55% or more and 95% or less. When Sdr is too large, an open circuit voltage (Voc) and a fill factor (FF) are decreased to consequently decrease Eff. Depending on the case, a short-circuit current density (Jsc) is decreased to consequently decrease a conversion efficiency (Eff). It is conceived that the reason why Voc and FF are decreased in the case where Sdr is large is that the surface roughness of the thin film solar cell substrate 1 is so acute that the coverage of the semiconductor layer 20 on the transparent electrode layer 12 becomes poor, and an increase in contact resistance and an increase in leak current are caused. It is conceived that the reason why Jsc is decreased in the case where Sdr is large is that the semiconductor layer 20 on the transparent electrode layer 12 is hindered from growing to deteriorate film quality, which results in an increase in loss due to carrier recombination. On the contrary, when Sdr is too small, it is conceived that the surface roughness of the thin film solar cell substrate 1 is so gentle as to weaken the optical confinement effect, whereby short-circuit current density (Jsc) is decreased to decrease Eff. Sdr may be set to an optimum value by controlling the film formation conditions of the ZnO layer. For example, the surface area ratio of the ZnO layer deposited by a low-pressure thermal CVD method varies so greatly with the film formation conditions such as a substrate temperature, a raw material gas flow rate and a pressure that the surface area ratio may be set to a desired value by controlling them.

An amorphous silicon based material is utilized for the front photoelectric conversion unit 2, which has sensitivity to light with a wavelength of approximately 360 to 800 nm; a crystalline silicon based material is utilized for the rear photoelectric conversion unit 3, which has sensitivity to light with a longer wavelength of up to approximately 1200 nm. Accordingly, the stacked thin film solar cell 5 including the front photoelectric conversion unit 2 made of an amorphous silicon based material and the rear photoelectric conversion unit 3 made of a crystalline silicon based material sequentially from the light incident side may effectively utilize incident light in a wider wavelength range.

A method for forming the conductive intermediate transmission reflective layer 6 having a lower refractive index than components of the units 2 and 3 between the semiconductor photoelectric conversion units 2 and 3 is used for further improving a conversion efficiency of the stacked thin film solar cell 5 (refer to Fig. 6). Such an intermediate transmission reflective layer 6 allows light of short-wavelength to be reflected and light of long-wavelength to be transmitted, so that efficient photoelectric conversion in each of the thin film photoelectric conversion units 2 and 3 is allowed.

For example, in the case where the intermediate transmission reflective layer 6 is inserted into the hybrid thin film solar cell 5 including the front amorphous silicon photoelectric conversion unit 2 and the rear crystalline silicon photoelectric conversion unit 3, current generated by the front unit 2 may be increased without increasing the thickness of an amorphous silicon photoelectric conversion layer 22. In the case of including the intermediate transmission reflective layer 6, the thickness of an amorphous silicon photoelectric conversion layer 22 necessary for obtaining the same output current value may be lessened as compared with the case of not including it, so that the characteristics of the amorphous silicon photoelectric conversion unit 2 may also be restrained from deteriorating due to photodegradation (Staebler-Wronsky effect), which becomes remarkable in accordance with an increase in the thickness of the amorphous silicon layer.

The intermediate transmission reflective layer may be placed in a part of a rear-side conductive type layer of the front photoelectric conversion unit, or in a part of a front-side conductive type layer of the rear photoelectric conversion unit.

The front photoelectric conversion unit 2 may be formed by superimposing each of the semiconductor layers in order of p-type, i-type and n-type by a plasma enhanced CVD method, for example. More specifically, the p-type amorphous silicon carbide layer 21 doped with boron of 0. 01 atomic % or more, the intrinsic amorphous silicon photoelectric conversion layer 22, and the n-type microcrystalline silicon layer 23 doped with phosphorus of 0.01 atomic % or more may be deposited in this order to form the amorphous silicon photoelectric conversion unit 2.

Conductive oxides such as zinc oxide and ITO may be utilized as a material for the intermediate transmission reflective layer 6, and a silicon composite layer containing microcrystalline silicon and silicon oxide formable by plasma enhanced CVD may also be used. In the case of the integrated type thin film solar cell 5, the use of a conductive oxide layer as the intermediate transmission reflective layer 6 may cause a problem of a short circuit of the rear photoelectric conversion unit 3, but yet a silicon composite layer is preferable by reason of not causing the problem. A silicon composite layer is preferably formed by plasma enhanced CVD on the conditions of a high $H_2/SiH_4$ ratio with the utilization of a $CO_2/SiH_4$ ratio in a range of 2 or more by using $SiH_4$, $CO_2$, $H_2$ and $PH_3$ as reactant gas. Plasma enhanced CVD on this occasion preferably utilizes on the conditions of a power supply frequency of 10 to 100 MHz, a high-frequency power density of 0.01 to 0.5 $W/cm^2$, a pressure of 50 to 1500 Pa, and a substrate temperature of 150 to 250°C by using a capacitive coupling-type parallel plate electrode. An increase in the $CO_2/SiH_4$ ratio may monotonously increase an oxygen concentration in the silicon composite layer to decrease a refractive index of the intermediate transmission reflective layer 6.

The rear photoelectric conversion unit 3 may also be formed by superimposing each of the semiconductor layers in order of p-type, i-type and n-type by a plasma enhanced CVD method, for example. More specifically, the p-type microcrystalline silicon layer 31 doped with boron of 0.01 atomic % or more, the intrinsic crystalline silicon photoelectric conversion layer 32, and the n-type microcrystalline silicon layer 33 doped with phosphorus of 0.01 atomic % or more may be deposited in this order to form the crystalline silicon photoelectric conversion unit 3.

The back face electrode layer 4 is preferably formed as at least one layer of a metal layer 42 containing at least one kind of Al, Ag, Au, Cu, Pt and Cr by a sputtering method or a vacuum deposition method. A conductive oxide layer 41 such as ITO, $SnO_2$ and ZnO is preferably formed as a part of the back face electrode layer 4 between the rear photoelectric conversion unit 3 and the metal layer 42. This conductive oxide layer 41 may improve adhesion properties between the rear photoelectric conversion unit 3 and the back face electrode layer 4, improve optical reflectance of the back face electrode layer 4, and act so that metallic element is prevented from diffusing from the metal layer 42 to the photoelectric conversion units 2 and 3.

The thin film solar cell may include two stacked photoelectric conversion units as a stacked thin film solar cell of Fig. 6, may be a thin film solar cell of the so-called single cell including only one photoelectric conversion unit, may be a thin film solar cell of the so-called triple cell including a three stacked photoelectric conversion unit, and may be with a stack of four or more photoelectric conversion units. For example, the thin film solar cell may be an amorphous single cell such that only the amorphous silicon photoelectric conversion unit corresponding to the front photoelectric conversion unit 2 of Fig. 6 is formed to omit the intermediate transmission reflective layer 6 and the rear photoelectric conversion unit 3. In the case of forming a transparent electrode layer with ZnO high in resistance to plasma as compared with $SnO_2$, the crystalline silicon photoelectric conversion unit may be directly formed on the transparent electrode layer. That is to say, a crystalline single cell including only the crystalline silicon photoelectric conversion unit may be formed without including the front photoelectric conversion unit 2 and the intermediate transmission reflective layer 6 of Fig. 6. Examples of the triple cell include a stack in order of an amorphous silicon photoelectric conversion unit/amorphous silicon germanium photoelectric conversion unit including an i layer of an amorphous silicon germanium/crystalline silicon photoelectric conversion unit, a stack in order of an amorphous silicon photoelectric conversion unit/crystalline silicon photoelectric conversion unit/crystalline silicon photoelectric conversion unit. In addition, a stacked thin film solar cell including the intermediate transmission reflective layer 6 is shown in Fig. 6, and it will be apparent that the present invention may also be applied to a stacked thin film solar cell with the intermediate transmission reflective layer 6 omitted.

Fig. 5 is a schematic cross-sectional view for describing an integrated structure of a thin film solar cell. In this integrated type thin film solar cell 901, the transparent electrode layer 12 is deposited on the transparent insulating substrate 11 including the transparent base material 111 made of glass and the foundation layer 112, and the semiconductor layer 20 including the amorphous silicon photoelectric unit 2, the intermediate transmission reflective layer 6 and the crystalline silicon photoelectric conversion unit 3 are deposited thereon, and the back face electrode layer 4 is deposited thereon (also refer to Fig. 6) .

As shown in Fig. 5, the integrated type thin film solar cell 901 is provided with the transparent electrode layer separation grooves 903, the back face electrode layer separation grooves 904 and the semiconductor layer separation grooves 905. These transparent electrode layer separation grooves 903, back face electrode layer separation grooves 904 and semiconductor layer separation grooves 905 are parallel to each other and extend in a direction perpendicular to the figure. The boundary between the adjacent photoelectric conversion cells 902 is prescribed by the transparent electrode layer separation grooves 903 and the back face electrode layer separation grooves 904.

The semiconductor layer separation grooves 905 are embedded with a metallic material contained in the back face electrode layer 4, and electrically connect the back face electrode 4 of one cell and the transparent electrode 12 of the other cell between the adjacent photoelectric conversion cells 902 . That is to say, the semiconductor layer separation grooves 905 and a metallic material to embed them serve to connect the adjacent photoelectric conversion cells 902 in series.

At least a part of the transparent electrode layer separation grooves, the back face electrode layer separation grooves and the semiconductor layer separation grooves is composed of a range of each pit having a maximum length W in a width direction of the separation grooves and a maximum length L in a longer direction as shown in a schematic plan view of Fig. 1. That is to say, setting W>L allows the width of the separation grooves to be widened without increasing energy for forming each pit. Then, the width of a constricted portion of the separation grooves may be widened between the adjacent pits, so that output characteristics, a yield and cost of the integrated type thin film solar cell can be improved while restraining a defect such that burrs remain in the grooves, a defect such that the pit row breaks partially (pit dislocation), and a defect such that the pit row curves partially (pit row curve).

On the other hand, in the case where the separation grooves are formed by linking conventional pits in a circular plane shape or longitudinal elliptic pits as in Patent Document 1, the plane area of the pits needs to be enlarged for widening the width of the separation grooves, so that an energy amount per 1 pulse of laser light needs to be enlarged in the case of utilizing the same laser energy density. For example, in the case of a longitudinal ellipse with W/L = 0. 5 in Patent Document 1, a quadruple area is necessary for realizing the same separation groove width as the case of a lateral ellipse with W/L = 2 in the present invention, so that a laser energy amount per 1 pulse needs to be also quadrupled. However, it is not preferable that an increase in a necessary laser energy amount increases cost of laser equipment. Ordinarily, energy distribution in a laser beam cross section is not necessarily uniform but is near to Gaussian distribution having a peak in the vicinity of the middle of the cross section. Accordingly, it is not preferable that an increase in an energy amount per 1 pulse of laser light heightens an energy peak in the pits to increase the damage to the ZnO layer.

Among the transparent electrode layer separation grooves 903, the semiconductor layer separation grooves 905 and the back face electrode layer separation grooves 904, in particular, setting the pits composing the back face electrode layer separation grooves 904 to a lateral shape with W>L is preferable for improving Voc, FF and Eff of the integrated type thin film solar cell to improve the yield thereof.

It is desirable that W/L is set to 1.25 or more for restraining the separation defect of the separation grooves, and it is desirable that W/L is set to 7.2 or less for restraining the generating area loss and resistance loss of the separation grooves. The maximum length d by which adjacent pits overlap in a longer direction of the separation grooves is set to 5% or more of L, so that the groove width in the boundary between the adjacent pits may be widened to restrain the separation defect of the separation grooves. On the contrary, the maximum length d of the overlap is set to 30% or less of L, so that the area of a portion on which a laser beam is irradiated with overlap is not enlarged too much, and the damage to the transparent electrode layer and a residue in the separation grooves can be restrained from occurring.

The plane shape of the pits may be various shapes as far as the condition W>L is satisfied, and an elliptic shape is preferable for the reason that a laser optical system may be easily composed and the laser conditions such as an energy amount and a focal distance are easily optimized. A typical plane shape of the pits is preferably an elliptic shape with W of 50 to 200 $\mu$m and L of 20 to 150 $\mu$m under the conditions of W>L. The maximum length d by which adjacent pits overlap in a longer direction of the separation grooves is preferably 6% or more and 33% or less of L, and typically d is preferably 5 to 40 $\mu$m.

The plane area of each of the pits is set to $3 \times 10^{-10}$ m$^2$ or more, so that the energy density for forming each of the pits is not increased too much, and the damage to the transparent electrode layer and a residue in the separation grooves may be restrained from occurring. On the other hand, the plane area of each of the pits is set to $4 \times 10^{-8}$ m$^2$ or less, so that an energy amount for forming each of the pits is not increased too much, and cost of laser equipment may be restrained from increasing and generating area loss due to the separation grooves may be restrained.

In a fabricating method of an integrated type thin film solar cell according to the present invention, the separation grooves may be formed by irradiating a laser beam in a pulse-like manner. YAG laser whose commercial product is easily available may be used as laser equipment. In that case, laser light with a wavelength of 1064 nm as the fundamental wave of YAG laser is used for forming the transparent electrode layer separation grooves, and laser light with a wavelength of 532 nm as the second harmonic of YAG laser is used for forming the semiconductor layer separation grooves and the back face electrode layer separation grooves. The separation grooves such that the pits in approximately the same shape range at a certain pitch may be formed by irradiating laser light in a pulse-like manner while changing a relative position between a laser beam irradiation spot and a substrate.

The frequency of a pulse of YAG laser may typically adopt 3 to 15 kHz. YVO4 (yttrium·vanadate) laser capable of emitting laser light with the same wavelength of 1064 nm as YAG laser may also be used for forming the separation grooves, in which case the pulse frequency may be increased to 30 kHz. A method for forming the separation grooves is not limited to laser beam irradiation but may be other energy beam irradiation. At least one of a reflecting mirror, a cylindrical lens and a slit in the XY direction in addition to an ordinary laser optical system may be properly used for satisfying W>L in the plane shape of the pits; thus, the pits in the desired plane shape may be realized.

The energy density of a laser beam for forming the back face electrode layer separation grooves is set to 1.1 times or more and 2 times or less of the minimum energy density capable of cutting the back face electrode layer; thus, the damage to the transparent electrode layer and a residue in the separation grooves may be restrained from occurring.

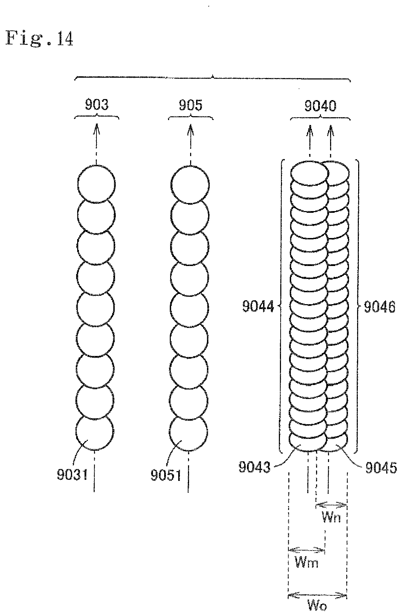

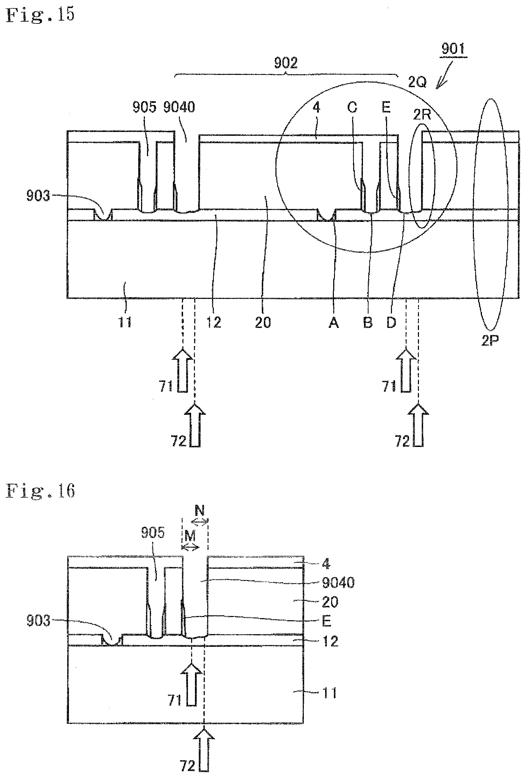

Another embodiment of the present invention is described below while referring to Figs. 4, 6 and 14 to 16. A cross-sectional view of Fig. 15 is schematically showing an integrated type thin film solar cell according to this embodiment with regard to a region surrounded by an ellipse 4P in Fig. 4. Then, Figs. 14 and 16 show while magnifying the transparent electrode layer separation grooves 903, the semiconductor layer separation grooves 905 and the back face electrode layer separation grooves 9040 in a schematic plan view and a schematic cross-sectional view respectively with regard to a region surrounded by an ellipse 2Q in Fig. 15. Fig. 6 may also be referred to as a schematic cross-sectional view showing in further detail stacked structure of a region surrounded by an ellipse 2P in Fig. 15.

In the integrated type thin film solar cell 901 shown in Fig. 15, the transparent electrode layer 12 is deposited on the transparent insulating substrate 11 including the glass base material 111 and the foundation layer 112, and the semiconductor layer 20 including the amorphous silicon photoelectric unit 2, the intermediate transmission reflective layer 6 and the crystalline silicon photoelectric conversion unit 3 are deposited thereon, and the back face electrode layer 4 is deposited thereon (also refer to Fig. 6).

As shown in Fig. 15, the integrated type thin film solar cell 901 is provided with the transparent electrode layer separation grooves 903, the back face electrode layer separation grooves 9040 and the semiconductor layer separation grooves 905. These transparent electrode layer separation grooves 903, back face electrode layer separation grooves 9040 and semiconductor layer separation grooves 905 are parallel to each other and extend in a direction perpendicular to the figure. The boundary between the adjacent photoelectric conversion cells 902 is prescribed by the transparent electrode layer separation grooves 903 and the back face electrode layer separation grooves 9040.

The semiconductor layer separation grooves 905 are embedded with a metallic material contained in the back face electrode layer 4, and electrically connect the back face electrode 4 of one cell and the transparent electrode 12 of the other cell between the adjacent photoelectric conversion cells 902. That is to say, the semiconductor layer separation grooves 905 and a metallic material to embed them serve to connect the adjacent photoelectric conversion cells 902 in series.

A method for forming the back face electrode layer separation grooves 9040 is illustrated while referring to Figs. 14 to 16. First, as shown as a first laser beam 71 in Figs. 15 and 16, a laser beam of the second harmonic (a wavelength of 532 nm) of YAG laser is irradiated on a region M through the transparent insulating substrate 11 to form the same back face electrode layer separation grooves as the back face electrode layer separation grooves 904 shown in Fig. 7.

Then, the back face electrode layer separation grooves to irradiate a second laser beam 72 on are selected. That is to say, in the case where the sufficiently favorable back face electrode layer separation grooves are formed by irradiating only the first laser beam, the irradiation of the second laser beam brings a possibility of increasing the damage of the transparent electrode layer, so that it is important that the number of the back face electrode layer separation grooves to irradiate the second laser beam on is set to the necessity minimum for reducing the damage. Thus, the presence or absence of a short circuit and leak current is inspected in each of the photoelectric conversion cells to be integrated, and the removal of a defective part is performed for only the back face electrode layer separation grooves contacting with the photoelectric conversion cells having output characteristics less than standard values by using the additional second laser beam.

As s method for the inspection, at least one method of the following may be adopted: (1) Voc, Jsc, FF and Eff etc. of each of the cells are actually measured by a solar simulator; (2) direct voltage or periodic voltage in the reverse direction is applied to each of the cells to determine by a value of leak current (this is called a reverse bias treatment); (3) to determine by whether volt-ampere characteristics denote diode characteristics by a curve tracer; (4) light having an intensity of approximately 10 mW/cm$^2$ is shined by a fluorescent lamp or the like to measure a relative value of Voc by a tester or the like; and (5) form observation is performed by a microscope. After the inspection, the second laser beam may be irradiated on the back face electrode layer separation grooves adjacent to the photoelectric conversion cells having output characteristics less than standard values over the whole groove longer direction, and in the case of specifying a defective part by a microscope, the second laser beam may be irradiated on only the defective part. The examples of a method for inspecting are enumerated herein and it is needless to say that other methods may also be adopted if the presence of a defective region may be determined.

Among the methods for inspecting exemplified herein, a reverse bias treatment is used in the fabricating processes of an ordinary thin film solar cell module. Accordingly, the use of the reverse bias treatment equipment allows the back face electrode layer separation grooves to irradiate the second laser beam on to be specified even though new inspecting equipment is not introduced.

In the reverse bias treatment, a short circuit portion is removed by applying a reverse direction voltage (reverse bias voltage) between the positive and negative electrodes of a cell. That is to say, electric current is concentrated on the short circuit portion by applying a reverse direction voltage on the semiconductor layer in a cell, and a conductive body in the short circuit portion is scattered or oxidized into an insulator by generated Joule heat to remove the short circuit portion. The short circuit portion is easily caused in a pinhole, the transparent electrode layer separation grooves and the back face electrode layer separation grooves in a cell. The bias processing equipment is provided with multistage probes contacting with the electrode of 3 to 6 adjacent cells, and the multistage probes are integrally lowered and contacted with the back face electrode layer.

For further details, a plurality of probes (this is called probes group) are provided for each cell at an interval of 10 to 100 mm in order to decrease contact resistance of the probes. 3 to 6 rows of cells may be processed by providing 4 to 7 rows of such probes group. That is to say, a pair of probes groups for applying reverse bias voltage on a pair of adjacent optional cells is selected by a circuit change switch to apply reverse bias voltage and measure leak current. When a reverse bias treatment of a cell at each row with which the probes group is connected is finished, all of the probes are integrally raised to relatively move a thin film solar cell module so that the rows of cells to be subsequently processed are disposed under the rows of probes, which are then integrally lowered.

In the determination by the reverse bias treatment, direct voltage or periodic waveshape voltage (such as half-wave rectified sine wave, rectangular wave and sawtooth wave) having a peak value of 2 V or less is first applied on a cell to measure leak current, and when the leak current is an allowable value or less, the reverse bias treatment is finished to determine that the cell passes the inspection. Even though leak current of a cell exceeds an allowable value in a voltage application of 2 V or less, in the case where the leak current becomes an allowable value or less by further increasing reverse bias voltage, it is determined that the cell also passes the inspection. On the other hand, even though reverse bias voltage is applied up to the previously predetermined maximum value, it is determined that the cell such that the leak current does not become an allowable value or less is rejected. Then, the second laser beam is additionally irradiated in the back face electrode layer separation grooves contacting with the cell rejected in the reverse bias treatment.

As shown in Fig. 16, similarly to the first laser beam 71, the second laser beam 72 with a wavelength of 532 nm is irradiated on a region N through the transparent insulating substrate 11 to thereby complete the back face electrode layer separation grooves 9040. On this occasion, the region N is partially overlaid on a region M, and the center of the region N is displaced from the center of the region M in a direction moving away from the nearest semiconductor layer separation grooves thereto. A circular shape and an elliptic shape may be preferably used as the cross-sectional shape of the laser beam, and an optional shape may also be used.

Incidentally, a residue E is attached to both walls of the grooves at the stage of forming the back face electrode layer separation grooves with only the first laser beam 71 (refer to Fig. 7), and causes a increase in leak current and a short circuit of an integrated type thin film solar cell. In the back face electrode layer separation grooves including the residue E, the second laser beam is irradiated on the region N including a portion of an ellipse 7P of Fig. 7, so that the residue E attached to the right wall of the back face electrode layer separation grooves is removed as shown in Fig. 16.

Herein, the residue E attached to the left wall of the back face electrode layer separation grooves 9040 does not need to be removed for the reason that the semiconductor layer separation grooves 905 on the left side thereof are embedded with a metallic material. However, the residue E attached to the right wall of the back face electrode layer separation grooves is a current leak path in a thickness direction in the cell on the right side thereof, so that it is important to shift the irradiated region N of the second laser beam to the right side. That is to say, the shift of the irradiated region N of the second laser beam to the right side allows the residue E on the right wall of the back face electrode layer separation grooves to be removed without broadening the width of the region N as compared with the region M. In the case of equalizing the region M with the region N in shape and area, the optical system for the first laser beam and the second laser beam may be the same, and the optical system and the control system become so convenient that the cost of laser equipment may be decreased. Also, the region N may be lessened as compared with the region M, in which case the energy density of the first laser beam and the second laser beam may be the same to reduce the energy cost.

As described above, according to the present invention, leak current and a short circuit in a thickness direction of the semiconductor layer is restrained from occurring, so that an integrated type thin film solar cell with Eff improved by an increase in Voc or FF may be provided at a high yield.

It is desirable that the cell contacting with the back face electrode layer separation grooves on which the second laser beam is additionally irradiated is subjected to the reverse bias treatment again. The reason therefor is that when a short circuit portion such as a minute residue remains also after irradiating the second laser beam, the reverse bias treatment again allows the short circuit portion to be removed.

A schematic plan view of Fig. 14 shows a part of the transparent electrode layer separation grooves 903, the semiconductor layer separation grooves 905, and the back face electrode layer separation grooves 9040 including a pit row formed by a pulse laser irradiation in the present invention. The transparent electrode layer separation grooves 903 are formed out of pits 9031 in approximately the circular shape ranging at a predetermined pitch. Similarly, the semiconductor layer separation grooves 905 are formed out of pits 9051 in approximately a circular shape ranging at a predetermined pitch.

On the other hand, the back face electrode layer separation grooves 9040 are formed out of the overlap of a first kind pit row 9044 such that a first kind pit 9043 in approximately an elliptic shape ranges at a predetermined pitch and a second kind pit row 9046 such that a second kind pit 9045 in approximately an elliptic shape ranges at a predetermined pitch. The local maximum length Wn of the second kind pit row 9046 in a groove width direction is smaller than the local maximum length Wm of the first kind pit row 9044 in a groove width direction. The center line of the second kind pit row 9046 is displaced from the center line of the first kind pit row 9044 in a direction moving away from the nearest semiconductor layer separation grooves 905 thereto.

In the present invention, a residue existing on the right sidewall of the first kind pit row 9044 is removed during the formation of the second kind pit row 9046; thus, an integrated type thin film solar cell with Eff improved by an increase in Voc or FF may be provided at an improved yield.

A difference in sizes by approximately ±20% and peeling of the back face electrode layer at the ends are occasionally found between the first kind pits 9043 included in the first kind pit row 9044, but yet the pits are approximately similar shapes as far as they are observed by an optical microscope with a magnification of approximately 100 to 1000.

In Fig. 14, the ratio Wo/Wm of the width Wo of the back face electrode layer separation grooves 9040 to the local maximum length Wm of the first kind pit row 9044 in a groove width direction, which is formed by only the irradiation of first laser beam, is preferably 1.15 or more and 1.8 or less. Setting this ratio to 1.15 or more causes the irradiated region M of the first laser beam not to overlap with the irradiated region N of the second laser beam too much (refer to Fig. 16), and the area on which the laser beam is irradiated twice is decreased so substantially that the damage to the transparent electrode layer may be reduced. Setting this ratio to 1.8 or less facilitates improvement and removal of a scribing faulty part (defective part) such as an uncut portion and a residue in the first kind pit row 9044 formed by the first laser beam, and may restrain a decrease in an effective electric generation area (area loss).

In the case of using zinc oxide (ZnO) for the transparent electrode layer, the utilization of the second laser beam irradiation is particularly effective. It is conceived that the reason therefor is that ZnO is vaporized so easily even at low temperature as compared with $SnO_2$ that the ZnO layer is easily vaporized while damaged by the first laser beam and the vaporized ZnO resolidifies and remain easily as a residue. It is also conceived that the ZnO layer is easily damaged by an increase in a laser light absorption amount, resulting from a large haze ratio and a thickness of the ZnO layer as compared with those of the $SnO_2$ layer.

It is more desirable that the energy density of the second laser beam is lowered as compared with the first laser beam. According to the studies of the inventors of the present invention, even though the energy density of the second laser beam is lowered, the residue E may be removed and the damage to the transparent electrode layer may also be decreased. Thus, Voc and FF are further increased to further improve an Eff and a yield of an integrated type thin film solar cell may also be improved. Setting the energy density of the second laser beam to 44% or more of the energy density of the first laser beam allows the residue E to be easily removed and allows leak current to be restrained, and setting the energy density of the second laser beam 95 or less of the first laser beam allows the damage of the transparent electrode layer in a region on which the laser beam is irradiated twice to be easily restrained. Therefore, it is desirable to set within the range of 44% or more and 95% or less. In addition, setting the energy density of the second laser beam to 50% or more and 70% or less of the energy density of the first laser beam allows the influence of the dispersion of the energy density to be decreased and allows a yield of an integrated type thin film solar cell to further improved, in the case of using a large-area substrate. The energy density may be lowered by decreasing the power of the laser, or by restraining a beam cross-sectional area in the irradiating position from being reduced while changing the focus depth of the laser beam.

Setting the number of the second laser beam irradiation (pulse number) per unit length of the back face electrode layer separation grooves to more than the number of the first laser beam irradiation raises a probability that a scribing faulty part (defective part) such as an uncut portion and a residue in the back face electrode layer separation grooves formed by the first laser beam can be improved and removed. It is desirable that the number of the second laser beam irradiation per unit length avoids integral multiple of the number of the first laser beam irradiation per unit length.

A narrow portion is formed in the boundary between the adjacent pits in a pit row formed by a pulse laser, and in this portion, the defects such as the residue E and uncut portion are easily caused. In the case where the number of the second laser beam irradiation per unit length is an integral multiple of the number of the first laser beam irradiation, a narrow portion in the boundary between the adjacent second kind pits 9045 formed by the second laser beam is occasionally in the same position as a narrow portion in the boundary between the adjacent first kind pits 9043 formed by the first laser beam. Then, the number of the second laser beam irradiation per unit length avoids integral multiple of the number of the first laser beam irradiation, so that the irradiation spot position of the second laser beam is shifted in a groove longer direction with respect to the irradiation spot position of the first laser beam, whereby the residue E may be removed more efficiently.

EXAMPLES

Various specific examples according to the present invention are described and studied below in detail with various comparative examples.

(Example 1)

An integrated type thin film solar cell was fabricated as Example 1 of the present invention. Also, with regard to this integrated type thin film solar cell of Example 1, Figs. 4 to 6 may be referred to. First, in order to obtain a transparent insulating substrate 11, a transparent foundation layer 112 containing $SiO_2$, particles 1121 was formed on a transparent base material 111 made of glass of 4 mm$\times$360 mm$\times$465 mm. The coating solution used for forming the transparent foundation layer 112 was such that tetraethoxysilane was added to a mixed solution of a fluid dispersion of globular silica with an average particle diameter of 100 nm, water and ethylcellosolve, and hydrochloric acid was added thereto to hydrolyze tetraethoxysilane and further add diacetone alcohol and propylene glycol as diluent. The ratio of globular silica to the whole coating solution was 6% by mass. The coating solution was applied on the glass base material by a printer, thereafter dried at a temperature of 90°C for 30 minutes, and then heated at a temperature of 450°C for 5 minutes to thereby obtain the transparent insulating substrate 11 having minute surface roughness (refer to Fig. 6).

A transparent electrode layer 12 of ZnO was formed on this transparent insulating substrate 11 by a low-pressure thermal CVD method. This transparent electrode layer 12 was formed under the conditions of a substrate temperature of 160°C, a pressure of 30 Pa, a flow rate of vaporized diethyl zinc (DEZ) of 200 sccm, a water vapor flow rate of 700 sccm, a diborane ($B_2H_6$) flow rate of 2 sccm, and a hydrogen flow rate of 1000 sccm.

Various physical characters measured with regard to the obtained ZnO transparent electrode layer 12 were such that the thickness measured from interference of reflection spectrum was 1.7 pm; the sheet resistance was 12.1 $\Omega/\square$; the haze ratio measured by using C light source was 21.6%; the carrier density measured from the Hall effect measurement was within the range from $5\times10^{19}$ to $3\times10^{20}/cm^3$ including the dispersion on the substrate plane; and the surface area ratio (Sdr) was 75.5%. Sdr in this patent application is measured from an atomic force microscope (AFM) image for observing a square region with a side of 5 $\mu$m. A noncontact mode of Nano-R system (manufactured by Pacific Nanotechnology Inc.) was used for this AFM measurement.

In addition, an impurity concentration in the ZnO transparent electrode layer 12 was measured as secondary ion mass spectrometry (SIMS) by using $Cs^+$ ion source. The elements of H, B and C were definitely detected as impurities in the ZnO layer by this SIMS. Each impurity concentration was distributed in a thickness direction of the ZnO layer; an H atom concentration was within the range from $9\times10^{20}$ to $3\times10^{21}/cm$, a B atom concentration was within the range from $1\times10^{20}$ to $4\times10^{20}/cm^3$, and a C atom concentration was within the range from $5\times10^{19}$ to $2\times10^{20}/cm^3$. Although, DEZ as the liquid raw material contains Al of approximately 0.1 to 2%, the Al atom concentration in the ZnO film measured by a high-resolution measurement of SIMS was $5\times10^{18}/cm^3$ or less. Accordingly, the Al atom concentration was lower than the carrier density by one digit more, so that it is understood that Al does not substantially act as a carrier in the ZnO layer.

An amorphous silicon photoelectric conversion unit 2, an intermediate transmission reflective layer 6, a crystalline silicon photoelectric conversion unit 3, and a back face electrode layer 4 were sequentially formed on the ZnO transparent electrode layer 12 as described above to thereby fabricate a stacked thin film solar cell as shown in Fig. 6. However, this thin film solar cell was fabricated as an integrated type thin film solar cell 901 as shown in Fig. 5 by utilizing laser scribing. 50 rows of photoelectric conversion cells were connected in series in the integrated type thin film solar cell 901 according to Example 1.

Specifically, transparent electrode layer separation grooves 903 were formed in the transparent electrode layer 12 by using a YAG laser beam having a wavelength of 1064 nm. The plane shape of each pit composing the grooves was formed to be in a circular shape as shown in Fig. 2 with the maximum length W in a groove width direction = 80 $\mu$m and the maximum length L in a groove longer direction = 80 $\mu$m. That is, W/L=1 and the area of each pit was $5.0\times10^{-9}$ $m^2$. The maximum length d by which adjacent pits overlap in a groove longer direction was set to 50% of L and the energy density of the laser beam was set to 13 J/cm². A thin film solar cell substrate 1 was washed and dried after forming the transparent electrode layer separation grooves 903.

The amorphous silicon photoelectric conversion unit 2 composed of a p-type layer 21 including a p-type microcrystalline silicon layer having a thickness of 10 nm and a p-type amorphous silicon carbide layer having a thickness of 15 nm, an intrinsic amorphous silicon photoelectric conversion layer 22 having a thickness of 350 nm, and an n-type microcrystalline silicon layer 23 having a thickness of 15 nm was formed on the transparent electrode layer 12 by a plasma enhanced CVD method. Subsequently, the intermediate transmission reflective layer 6 composed of a silicon composite layer having a thickness of 50 nm was formed by a plasma enhanced CVD method. In addition, the crystalline silicon photoelectric conversion unit 3 composed of a p-type microcrystalline silicon layer 31 having a thickness of 15 nm, an intrinsic crystalline silicon layer 32 having a thickness of 2.5 $\mu$m, and an n-type microcrystalline silicon layer 33 having a thickness of 15 nm was formed by a plasma enhanced CVD method. That is, a semiconductor layer 20 included a front photoelectric conversion unit 2, the intermediate transmission reflective layer 6 and a rear photoelectric conversion unit 3.

Thereafter, semiconductor layer separation grooves 905 piercing through the semiconductor layer 20 were formed by laser scribing with the use of the second harmonic (a wavelength of 532 nm) of YAG laser. The plane shape of each pit composing these grooves was formed to be in a longitudinal elliptic shape having the major axis in a groove longer direction as shown in Fig. 3 with the maximum length W in a groove width direction = 50 $\mu$m and the maximum length L in a groove longer direction = 80 $\mu$m. That is, W/L=0.63 and the area of each pit was $3.1 \times 10^{-9}$ m$^2$. The maximum length d by which adjacent pits overlap in a groove longer direction was set to 50% of L and the energy density of the laser beam was set to 0.7 J/cm$^2$.

An Al-doped ZnO layer 41 having a thickness of 90 nm and an Ag layer 42 having a thickness of 200 nm were sequentially formed as the back face electrode layer 4 by a sputtering method on the semiconductor layer 20 with the semiconductor layer separation grooves 905 formed.

Lastly, back face electrode layer separation grooves 904 piercing through the front photoelectric conversion unit 2, the intermediate transmission reflective layer 6, the rear photoelectric conversion unit 3 and the back face electrode layer 4 were formed by laser scribing with the use of the second harmonic (a wavelength of 532 nm) of a YAG laser. The plane shape of each pit composing these grooves was formed to be in a lateral elliptic shape having the minor axis in a groove longer direction as shown in Fig. 1 with the maximum length W in a groove width direction = 75 $\mu$m and the maximum length L in a groove longer direction = 60 $\mu$m. That is, W/L=1.25 and the area of each pit was $3.3 \times 10^{-9}$ m$^2$. The maximum length d by which adjacent pits overlap in a groove longer direction was set to 20% of L and the energy density of the laser beam was set to 0.7 J/cm$^2$.

The light with air mass (AM) of 1.5 was irradiated on the integrated type thin film solar cell according to Example 1 thus obtained with a light intensity of 100 mW/cm$^2$, and then output characteristics measured an open circuit voltage (Voc) of 1. 313 V, a short-circuit current density (Jsc) of 12.59 mA/cm$^2$, a fill factor (FF) of 0.712 and a conversion efficiency (Eff) of 11.77%.

When the presence or absence of a short circuit in each of the photoelectric conversion cells was inspected by a curve tracer before the back side of this integrated type thin film solar cell according to Example 1 was sealed with resin, no short-circuited cells were found in all of the 50 rows of photoelectric conversion cells. That is, in the plane shape of each pit composing the back face electrode layer separation grooves 904, the maximum length W in a groove width direction and the maximum length L in a groove longer direction were set to a relation of W/L=1.25, whereby it is understood that an integrated type thin film solar cell having a high Eff of more than 11.5% is obtained.

In the case where the energy density of the laser beam for forming the back face electrode layer separation grooves 904 was set to less than 0.6 J/cm$^2$, an uncut portion was caused in the back face electrode layer. That is, the energy density of the laser beam used for forming the back face electrode layer separation grooves 904 in Example 1 is equivalent to 1.17 times of the minimum energy density of the laser beam capable of cutting the back face electrode layer.

(Example 2)

An integrated type thin film solar cell similar to Example 1 was fabricated also in Example 2 of the present invention. That is, an integrated type thin film solar cell of Example 2 was different from Example 1 only in modifying the plane shape of each pit composing the back face electrode layer separation grooves 904.

In Example 2, the plane shape of each pit composing the back face electrode layer separation grooves 904 was formed to be in a lateral elliptic shape having the minor axis in a groove longer direction as shown in Fig. 1 with the maximum length W in a groove width direction = 90 $\mu$m and the maximum length L in a groove longer direction = 50 $\mu$m. That is, W/L=1.80 and the area of each pit was $3.5 \times 10^{-9}$ m$^2$. The maximum length d by which adjacent pits overlap in a groove longer direction was set to 20% of L and the energy density of the laser beam was set to 0.7 J/cm$^2$.

When the output characteristics of the obtained integrated type thin film solar cell according to Example 2 were measured in the same manner as the case of Example 1, Voc was 1.328 V, Jsc was 12. 65 mA/cm$^2$, FF was 0.714 and Eff was 12.00%. When the presence or absence of a short circuit in the photoelectric conversion cells was inspected also in Example 2 by the same method as in Example 1, no short-circuited cells were found in all of the 50 rows of photoelectric conversion cells.

It is understood from the comparison between Example 2 and Example 1 that the increase of W/L from 1.25 to 1.8 in each pit composing the back face electrode layer separation grooves 904 further improves Eff from 11.77% to 12.00%.

Fig. 8 is an optical microphotograph showing the top face of a part of the back face electrode layer separation grooves 904 in Example 2. The burrs of a metallic material contained in the back face electrode layer 4 in the proximity of the back face electrode layer separation grooves 904 are observed from this optical microphotograph, and setting W/L>1 increases the groove width so sufficiently that the size of the burrs become smaller than the groove width and it is found that no short circuits are caused.

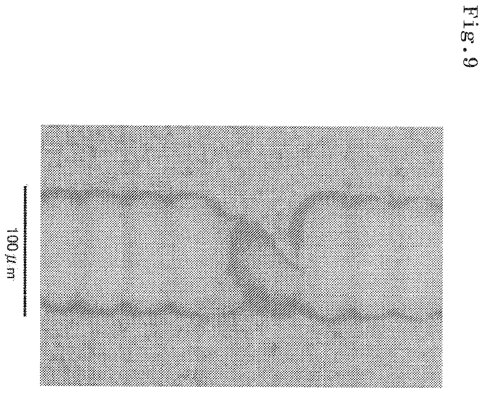

Fig. 9 is an optical microphotograph showing another part of the back face electrode layer separation grooves 904 in Example 2. In this Fig. 9, one of the pits to compose the back face electrode layer separation grooves 904 becomes smaller and partial pit dislocation is caused. However, setting W/L>1 increases the width of the pits so sufficiently that the separation grooves do not completely break and it is found that no short circuits are caused. That is, it is found that setting W/L>1 may decrease a probability of short-circuiting even though burrs and pit dislocation are caused.

(Comparative Example 1)

An integrated type thin film solar cell similar to Example 1 was fabricated also in Comparative Example 1. That is, an integrated type thin film solar cell of Comparative Example 1 was different from Example 1 only in modifying the plane shape of each pit composing the back face electrode layer separation grooves 904.

In Comparative Example 1, the plane shape of each pit composing the back face electrode layer separation grooves 904 was formed to be in a circular shape as shown in Fig. 2 with the maximum length W in a groove width direction = 63 $\mu$m and the maximum length L in a groove longer direction = 63 $\mu$m. That is, W/L=1.00 and the area of each pit was $3,3 \times 10^{-9}$ m$^2$. The maximum length d by which adjacent pits overlap in a groove longer direction was set to 20% of L and the energy density of the laser beam was set to 0.7 J/cm$^2$.

When the output characteristics of the obtained integrated type thin film solar cell according to Comparative Example 1 were measured in the same manner as the case of Example 1, Voc was 1.272 V, Jsc was 12.69 mA/cm$^2$, FF was 0.643 and Eff was 10.38%. When the presence or absence of a short circuit in the photoelectric conversion cells was inspected also in Comparative Example 1 by the same method as in Example 1, two short-circuited cells were found in all of the 50 rows of photoelectric conversion cells.

It is understood from the comparison between Comparative Example 1 and Examples 1 and 2 that setting W/L=1 in the back face electrode layer separation grooves 904 decreases Voc and FF to decrease Eff to a low value of less than 10.5%. Then, the cause thereof is conceived to be a short circuit of the photoelectric conversion cells.

(Comparative Example 2)

An integrated type thin film solar cell similar to Example 1 was fabricated also in Comparative Example 2. That is, an integrated type thin film solar cell of Comparative Example 2 was different from Example 1 only in modifying the plane shape of each pit composing the back face electrode layer separation grooves 904.

The shape of each pit in Comparative Example 2 was formed to be in a longitudinal elliptic shape having the major axis in a groove longer direction as snown in Fig. 3 with the maximum length W in a groove width direction = 50 $\mu$m and the maximum length L in a groove longer direction = 80 $\mu$m. That is, W/L=0. 63 and the area of each pit was $3.1 \times 10^{-9}$ m$^2$. The maximum length d by which adjacent pits overlap in a groove longer direction was set to 20% of L and the energy density of the laser beam was set to 0.7 J/cm$^2$.

When the output characteristics of the obtained integrated type thin film solar cell according to Comparative Example 2 were measured in the same manner as the case of Example 1, Voc was 1.306 V, Jsc was 12.72 mA/cm$^2$, FF was 0.623 and Eff was 8.84%. When the presence or absence of a short circuit in the photoelectric conversion cells was inspected also in Comparative Example 2 by the same method as in Example 1, six short-circuited cells were found in all of the 50 rows of photoelectric conversion cells.

It is understood from the comparison between Comparative Example 2 and Comparative Example 1 that setting W/L<1 decreases Voc and FF further than the case of W/L=1 of Comparative Example 1 to decrease Eff to a low value of less than 9%. Then, the cause of the decrease of Eff is conceived to be a high probability of short-circuiting the photoelectric conversion cells.

Fig. 10 is an optical microphotograph showing the top face of a part of the back face electrode layer separation grooves 904 in Comparative Example 2. In this optical microphotograph, one of the pits to compose the grooves lacks in the back face electrode layer separation grooves 904 and pit dislocation is caused. That is, the successive pit row breaks in a place and a short circuit is caused between the photoelectric conversion cells on both sides of these back face electrode layer separation grooves 904. When other short-circuited photoelectric conversion cells were inspected in Comparative Example 2, the occurrence of pit dislocation or burrs over the back face electrode layer separation grooves were confirmed. That is, the case of W/L<1, it is conceived that pit dislocation and burrs are caused so easily as to bring a short circuit of the photoelectric conversion cells easily.

(Comparative Example 3)

An integrated type thin film solar cell similar to Example 2 was fabricated in Comparative Example 3. That is, an integrated type thin film solar cell of Comparative Example 3 was different from Example 2 only in three respects that no transparent foundation layer 112 was formed, a ZnO layer was replaced as a transparent electrode layer with an $SnO_2$ layer, and an energy density of a laser beam in forming the back face electrode layer separation grooves was modified into 0.8 J/cm2. A commercial product such that the $SnO_2$ electrode layer 12 was formed by a thermal CVD method was used as the thin film solar cell substrate 1, in which product the haze ratio was 13.2% and the sheet resistance of the $SnO_2$ electrode layer was 12.5 Ω/□. The plane shape of each pit composing the back face electrode layer separation grooves 904 in Comparative Example 3 was the same as the case of Example 2, that is, the maximum length W in a groove width direction = 90 μm, the maximum length L in a groove longer direction = 50 μm, and W/L=1.80.

When the output characteristics of the obtained integrated type thin film solar cell according to Comparative Example 3 were measured in the same manner as the case of Example 1, Voc was 1.362 V, Jsc was 11.63 mA/cm2, FF was 0.722 and Eff was 11.44%. When the presence or absence of a short circuit in the photoelectric conversion cells was inspected also in Comparative Example 3 by the same method as in Example 1, no short-circuited cells were found in all of the 50 rows of photoelectric conversion cells.

It is understood from the comparison between Comparative Example 3 and Example 2 that the case where the ZnO layer on the transparent foundation layer 112 was replaced as the transparent electrode layer 12 with the $SnO_2$ layer with no foundation layer required decreases Jsc to thereby decrease Eff. The cause thereof is conceived to be such that in the thin film solar cell substrate including as the transparent electrode layer the $SnO_2$ layer with no foundation layer required instead of the ZnO layer on the foundation layer, the haze ratio was decreased to weaken the optical confinement effect.

(Comparative Example 4)

An integrated type thin film solar cell similar to Comparative Example 3 was fabricated in Comparative Example 4. That is, an integrated type thin film solar cell of Comparative Example 4 was different from Comparative Example 3 only in modifying the plane shape of each pit composing the back face electrode layer separation grooves 904. The plane shape of each pit in Comparative Example 4 was the same as the case of Comparative Example 2, that is, the maximum length W in a groove width direction = 50 μm, the maximum length L in a groove longer direction = 80 μm, and W/L=0.63.

When the output characteristics of the obtained integrated type thin film solar cell according to Comparative Example 4 were measured in the same manner as the case of Example 1, Voc was 1.362 V, Jsc was 11.63 mA/cm2, FF was 0.722 and Eff was 11.44%. When the presence or absence of a short circuit in the photoelectric conversion cells was inspected also in Comparative Example 4 by the same method as in Example 1, no short-circuited cells were found in all of the 50 rows of photoelectric conversion cells.

In the comparison between Example 2 and Comparative Example 2 using the ZnO transparent electrode layer as described above, Eff is remarkably decreased in the case of W/L<1 as compared with the case of W/L>1 in the plane shape of each pit composing the back face electrode layer separation grooves 904; yet, it is understood that in the comparison between Comparative Example 4 and Comparative Example 3 using the $SnO_2$ transparent electrode layer, Voc, Jsc and FF are approximately equal and Eff does not change even in the case of W/L<1 as compared with the case of W/L>1. It is conceived that the reason therefor is that when the transparent electrode layer 12 was $SnO_2$, the $SnO_2$ transparent electrode layer 12 was hardly damaged in forming the back face electrode layer separation grooves 904 and an energy density of a laser beam may be increased from 0.7 J/cm2 to 0.8 J/cm2.

(Example 3)

An integrated type thin film solar cell similar to Example 1 was fabricated also in another Example 3 of the present invention. That is, an integrated type thin film solar cell of Example 3 was different from Example 1 only in modifying the plane shape of each pit composing the back face electrode layer separation grooves 904. The plane shape of each pit in Example 3 was formed to be in a lateral elliptic shape having the minor axis in a groove longer direction with the maximum length W in a groove width direction =110 μm and the maximum length L in a groove longer direction = 35 μm. That is, W/L=3.14 and the area of each pit was $30 \times 10^{-9}$ m2. The maximum length d by which adjacent pits overlap in a groove longer direction was set to 20% of L and the energy density of the laser beam was set to 0.7 J/cm2.

When the output characteristics of the obtained integrated type thin film solar cell according to Example 3 were measured in the same manner as the case of Example 1, Voc was 1.326 V, Jsc was 12.52 mA/cm2, FF was 0.711 and Eff was 11.82%. When the presence or absence of a short circuit in the photoelectric conversion cells was inspected also in Example 3 by the same method as in Example 1, no short-circuited cells were found in all of the 50 rows of photoelectric conversion cells.

It is understood from the comparison between Example 3 and Example 2 that as high Eff as 11.5% or more is still obtained even though W/L is further increased from 1.80 to 3.14 in each pit composing the back face electrode layer separation grooves 904.

(Example 4)

An integrated type thin film solar cell similar to Example 1 was fabricated also in another Example 4 of the present invention. That is, an integrated type thin film solar cell of Example 4 was different from Example 1 only in modifying the plane shape of each pit composing the back face electrode layer separation grooves 904. The plane shape of the pits in Example 4 was formed to be in a lateral elliptic shape having the minor axis in a groove longer direction with the maximum length W in a groove width direction = 170 $\mu$m and the maximum length L in a groove longer direction = 25 $\mu$m. That is, W/L=6.80 and the area of each pit was $3.5 \times 10^{-9}$ m$^2$. The maximum length d by which adjacent pits overlap in a groove longer direction was set to 20% of L, and the energy density of the laser beam was set to 0.7 J/cm$^2$.

When the output characteristics of the obtained integrated type thin film solar cell according to Example 4 were measured in the same manner as the case of Example 1, Voc was 1.327 V, Jsc was 12.43 mA/cm$^2$, FF was 0.711 and Eff was 11.73%. When the presence or absence of a short circuit in the photoelectric conversion cells was inspected also in Example 4 by the same method as in Example 1, no short-circuited cells were found in all of the 50 rows of photoelectric conversion cells.

It is understood from the comparison between Example 4 and Example 3 that as high Eff as 11.5% or more is still obtained even though W/L is further increased from 3.14 to 6.80 in each pit composing the back face electrode layer separation grooves 904.

(Summary of Examples 1 to 4 and Comparative Examples 1 to 4)

Fig. 11 is a graph showing the relation of Eff (%) of an integrated type thin film solar cell to W/L in each pit composing back face electrode layer separation grooves, with regard to the above-mentioned Examples 1 to 4 and Comparative Examples 1 to 4. As is understood from the above-mentioned Examples and Comparative Examples, in this graph, the area of each pit is maintained approximately constantly within the range from 3.0 to $3.5 \times 10^{-9}$ m$^2$, while W/L is variously changed.

As clarified from Fig. 11, in the case of using ZnO for the transparent electrode layer, an increase in W/L improves Eff abruptly and the setting to W/L>1 increases Eff to as comparatively high a value as 10.5% or more. In addition, it is understood that W/L in a range of 1.25 or more and 7.2 or less allows as high Eff as 11.5% or more. That is, in an integrated type thin film solar cell with ZnO used for the transparent electrode layer, it will be understood that W/L is preferably set to W/L>1, more preferably set to 1.25 or more and 7.2 or less. In Fig. 11, Eff has a local maximum value with regard to W/L and Eff is the largest in W/L of approximately 1.8.

On the other hand, in the case of using the transparent electrode layer made of SnO$_2$ as in Comparative Examples 3 and 4, Eff is approximately equal between Comparative Example 3 of W/L>1 and Comparative Example 4 of W/L<1 and significant difference is not recognized. Also, significant difference does not exist in Voc, Jsc and FF between Comparative Examples 3 and 4. Accordingly, it will be understood that the effect of W/L in each pit composing back face electrode layer separation grooves on Eff of an integrated type thin film solar cell is a characteristic effect in the case of using ZnO for the transparent electrode layer.

(Example 5)

An integrated type thin film solar cell similar to Example 2 was fabricated in Example 5 of the present invention. That is, an integrated type thin film solar cell of Example 5 was different from Example 2 only in applying the condition of W/L>1 to each pit composing the semiconductor layer separation grooves 905 in addition to the back face electrode layer separation grooves 904. More specifically, in Example 5, the plane shape of each pit composing the semiconductor layer separation grooves 905 was formed to be in a lateral elliptic shape having the minor axis in a groove longer direction as shown in Fig. 1 with the maximum length W in a groove width direction = 90 $\mu$m and the maximum length L in a groove longer direction = 50 $\mu$m. That is, W/L=1. 80 and the area of each pit was $3.5 \times 10^{-9}$ m$^2$. The maximum length d by which adjacent pits overlap in a groove longer direction was set to 20% of L and the energy density of the laser beam was set to 0.7 J/cm$^2$.

When the output characteristics of the obtained integrated type thin film solar cell according to Example 5 were measured in the same manner as the case of Example 1, Voc was 1.345 V, Jsc was 12.80 mA/cm$^2$, FF was 0.717 and Eff was 12.34%. When the presence or absence of a short circuit in the photoelectric conversion cells was inspected also in Example 5 by the same method as in Example 1, no short-circuited cells were found in all of the 50 rows of photoelectric conversion cells.

It is understood from the comparison between Example 5 and Example 2 that the application of the condition of W/L>1 to each pit composing the semiconductor layer separation grooves 905 in addition to the back face electrode layer separation grooves 904 further improves Eff from 12.00% to 12.34%.

(Example 6)

An integrated type thin film solar cell similar to Example 5 was fabricated in Example 6 of the present invention. That is, an integrated type thin film solar cell of Example 6 was different from Example 5 only in applying the condition of W/L>1 to each pit composing the transparent electrode layer separation grooves 903 in addition to the back face electrode layer separation grooves 904 and the semiconductor layer separation grooves 905. More specifically, in Example 6, the plane shape of each pit composing the transparent electrode layer separation grooves 903 was formed to be in a lateral elliptic shape having the minor axis in a groove longer direction as shown in Fig. 1 with the maximum length W in a groove width direction = 90 $\mu$m and the maximum length L in a groove longer direction = 50 $\mu$m. That is, W/L=1.80 and the area of each pit was $3.5 \times 10^{-9}$ m$^2$ . The maximum length d by which adjacent pits overlap in a groove longer direction was set to 20% of L and the energy density of the laser beam was set to 13 J/cm$^2$.

When the output characteristics of the obtained integrated type thin film solar cell according to Example 6 were measured in the same manner as the case of Example 1, Voc was 1.345 V, Jsc was 12.83 mA/cm$^2$, FF was 0.722 and Eff was 12.45%. When the presence or absence of a short circuit in the photoelectric conversion cells was inspected also in Example 6 by the same method as in Example 1, no short-circuited cells were found in all of the 50 rows of photoelectric conversion cells.

It is understood from the comparison between Example 6 and Examples 2 and 5 that the application of the condition of W/L>1 to each pit composing the transparent electrode layer separation grooves 903 in addition to the back face electrode layer separation grooves 904 and the semiconductor layer separation grooves 905 further improves Eff from 12.00% or 12.34% to 12.45%.

(Example 7)

In Example 7, the influence of the ratio d/L of a maximum length d by which adjacent pits overlap in a groove longer direction to a maximum length L in a groove longer direction of each pit on groove width was studied by calculation. The conditions of W = 90 $\mu$m, L = 50 $\mu$m and W/L=1.80 with regard to the pit of Example 2 having the highest Eff in Fig. 11 were assumed in the calculation.

In Example 7, a minimum width V of separation grooves was measured in the relation with d/L. This minimum width V corresponds to the width in a narrow portion of the grooves in the boundary between the adjacent pits. When the center of an ellipse as the plane shape of the pits is regarded as the origin and the x-axis and the y-axis are regarded as a groove width direction and a groove longer direction respectively, the y-coordinate of an intersection point of adjacent ellipses is represented by the following expression (1).

$$y=L/2-d/2 \qquad\qquad \text{Expression (1)}$$

Herein, the use of a parameter $\theta$ allows the y-coordinate to be represented by the following expression (2).

$$y=(L/2)\times\sin\theta \qquad\qquad \text{Expression (2)}$$

The expressions (1) and (2) are equal; therefore, the following expression (3) is obtained.

$$L/2-d/2=(L/2)\times\sin\theta \qquad\qquad \text{Expression (3)}$$

This expression (3) allows the following expression (4) .

$$\theta=\arcsin\{(L-d)/d\} \qquad\qquad \text{Expression (4)}$$

On the other hand, the x-coordinate of an intersection point of adjacent ellipses offers two solutions, which are positive and negative value, and may be represented by the following expression (5).

$$x=(W/2) \times \cos\theta, \quad x=-(W/2) \times \cos\theta \qquad \text{Expression (5)}$$

The expressions (3), (4) and (5) allow V to be represented by the following expression (6).

$$V=(W/2) \times \cos\theta-\{-(W/2) \times \cos\theta\}$$
$$= W\cos\theta$$
$$=W\cos(\arcsin\{(L-d)/d\}) \qquad \text{Expression (6)}$$

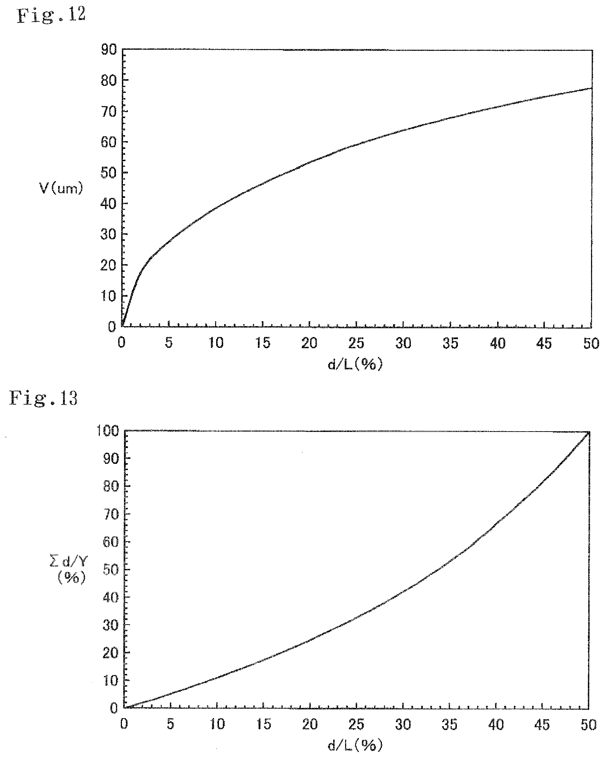

Fig. 12 is a graph showing the relation of V to d/L. As is understood from this graph, V tends to be increased and gradually saturated in accordance with an increase in d/L. It is conceived that V needs 30 $\mu$m at the minimum in view of the size of burrs and pit dislocation in the microphotographs shown in Figs. 8 to 10. In the graph of Fig. 12, it is understood that d/L needs to be set to 6% or more for setting V to 30 $\mu$m.

(Example 8)

In Example 8, the influence of the ratio d/L of a maximum length d by which adjacent pits overlap in a groove longer direction to a maximum length L in a groove longer direction of the pits on the ZnO transparent electrode layer was studied by calculation. The ratio $\Sigma$d/Y of the total $\Sigma$d of overlap length of pits to the full length Y of separation grooves was measured in the calculation. A distance by which the scanning of laser beams travels in each pulse is (L-d), and the following expressions (7) and (8) are obtained when the number of pulses per one separation groove is regarded as n.

$$Y=(L-d) \times n \qquad \text{Expression (7)}$$

$$\Sigma d=d \times n \qquad \text{Expression (8)}$$

Accordingly, the expressions (7) and (8) allow the following expression (9).

$$\Sigma d/Y=d/(L-d) \qquad \text{Expression (9)}$$

Fig. 13 is a graph showing the relation of $\Sigma$d/Y (%) to d/L (%). In this graph, $\Sigma$d/Y is increased while increasing the gradient in accordance with an increase in d/L. It is conceived that the ZnO transparent electrode layer is greatly damaged for the reason that the laser beam is irradiated twice on a portion in which adjacent pits overlap. In order to reduce such damage, it is desirable that the portion in which the pits overlap is a half or less of the full length of separation grooves, that is, $\Sigma$d/Y is 50% or less. Then, it is understood from the graph of Fig. 13 that d/L needs to be set to 33% or less for setting $\Sigma$d/Y to 50% or less.

(Example 9)

An integrated type thin film solar cell similar to Example 1 was fabricated also in Example 9. That is, an integrated type thin film solar cell of Example 9 was different from Example 1 only in three respects that the film thickness of the intermediate transmission reflective layer 6 composed of a silicon composite layer was set to 70 nm, the film thickness of the intrinsic crystalline silicon layer 32 of the crystalline photoelectric conversion unit 3 was set to 2.9 $\mu$m, and the fabricating method and structure of the back face electrode layer separation grooves are modified.

The ZnO transparent electrode layer 12, the amorphous silicon photoelectric conversion unit 2, the intermediate transmission reflective layer 6, the crystalline silicon photoelectric conversion unit 3, and the back face electrode layer 4 were sequentially formed on the transparent insulating substrate 11 to there by fabricate a stacked thin film solar cell as shown in Fig. 6. However, this thin film solar cell was fabricated as an integrated type thin film solar cell 901 as shown in Fig. 15 by utilizing laser scribing. 50 rows of photoelectric conversion cells were connected in series in the integrated type thin film solar cell 901 according to Example 9.

After forming the back face electrode layer 4, the back face electrode layer separation grooves 9040 piercing through the front photoelectric conversion unit 2, the intermediate transmission reflective layer 6, the rear photoelectric conversion unit 3 and the back face electrode layer 4 were formed by laser scribing with the use of the second harmonic (a wavelength of 532 nm) of a YAG laser. First, the first laser beam 71 was irradiated on the irradiated region M of a lateral elliptic shape having the minor axis in a groove longer direction (the maximum length in a groove width direction is approximately 70 $\mu$m and the maximum length in a groove longer direction is approximately 50 $\mu$m) to obtain the first kind pit row 9044 such that the first kind elliptic pit 9043 with the maximum length in a groove width direction of 70 $\mu$m and the maximum length in a groove longer direction of 50 $\mu$m as shown in Fig. 14 ranges at a predetermined pitch. That is, the local maximum width Wm of this first kind pit row 9044 was approximately 70 $\mu$m. The energy density of the first laser beam 71 was set to 0.7 J/cm$^2$ and the processing rate was set to 600 mm/s in this Example.

Thereafter, the reverse bias treatment was performed, and two cells were rejected by reason of leak current over an allowable value. Then, the second laser beam 72 was additionally irradiated only on the back face electrode layer separation grooves contacting with these two rejected cells. The center of an irradiated region N of a lateral elliptic shape having the minor axis in a groove longer direction (the maximum length in a groove width direction is approximately 70 $\mu$m and the maximum length in a groove longer direction is approximately 50 $\mu$m) was displaced by approximately 35 $\mu$m from the center of an irradiated region M in a direction moving away from the nearest semiconductor layer separation grooves 905 thereto so that the irradiated region N of the second laser beam overlaps partially with the irradiated region M of the first laser beam. Thus, as shown in Fig. 14, the second kind pit row 9046 such that the second kind pit 9045 ranges at a predetermined pitch was obtained. The energy density of the second laser beam 72 was set to 0.7 J/cm$^2$ and the processing rate was set to 600 mm/s. The local maximum length Wn in a groove width direction of the second kind pit row 9046 was contracted to 41 $\mu$m by overlap with the first kind pit row 9044. Then, the local maximum width Wo of the back face electrode layer separation grooves 9040 was 105 $\mu$m and Wo/Wm was 1.5.

When the two rejected cells before irradiating the second laser beam were subjected to a reverse bias treatment again after irradiating the second laser beam, leak current in either of the two cells became an allowable value or less and both of the cells were determined to be acceptable

The light with air mass (AM) of 1.5 was irradiated on the integrated type thin film solar cell according to Example 9 thus obtained with a light intensity of 100 mW/cm$^2$, and then output characteristics measured an open circuit voltage (Voc) of 1.364 V, a short-circuit current density (Jsc) of 13.49 mA/cm$^2$, a fill factor (FF) of 0.734 and a conversion efficiency (Eff) of 13.50% per 1 cm$^2$ of one cell. The integrated type thin film solar cell was fabricated by 100 pieces in Example 9 and then a yield of the integrated type thin film solar cell having an Eff of 12% or more was 94%.

When the presence or absence of leak current and a short circuit in each of the photoelectric conversion cells was inspected by a curve tracer before the back side of this integrated type thin film solar cell according to Example 9 was sealed with resin, no cells with a short circuit or leak current were found in all of the 50 rows of photoelectric conversion cells.

The light of a fluorescent lamp with intensity of approximately 10 mW/cm$^2$ was irradiated to the photoelectric conversion cells to measure an output voltage (Vfl) of each of the photoelectric conversion cells by a tester. Although, Vfl varied somewhat with light quantity distribution of the fluorescent lamp, any cells in Example 9 offered Vfl of 0.8 V or more. That is, it can be determined that normal photoelectric conversion cells with less short circuit or leak current have Vfl of 0.8 V or more, and that the photoelectric conversion cells having Vfl of less than 0.8 V offer large leak current. Vfl of normal cells scarcely changes unless kind and superimposition number of the photoelectric conversion units included in the photoelectric conversion cells change, so that the cells may be easily inspected by measuring Vfl.

In Example 9, photographing and component analysis of a cross-sectional SEM image of the integrated type thin film solar cell were also performed by using a scanning electron microscope (SEM). An energy dispersive x-ray spectroscope (EDX) attached to SEM was used for analysis of the component.

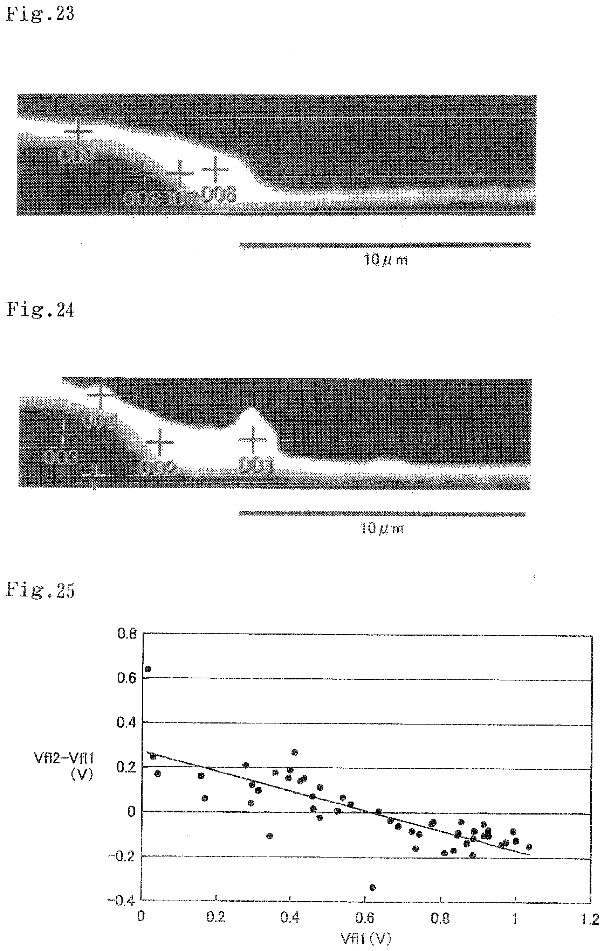

Fig. 23 shows a cross-sectional SEM image in the left-to-right reversal relation of an elliptic region 2R in Fig. 15. That is, a stepped portion on the left side in Fig. 23 corresponds to the right sidewall of the back face electrode layer separation grooves 9040 in Fig. 15. It is understood from Fig. 23 that the wall surface of the back face electrode layer separation grooves is smooth and no large residue exists.

[Table 1]

| Measuring point | O (atomic %) | Zn (atomic %) |
|---|---|---|
| 006 | 23.6 | 2.5 |
| 007 | 13.9 | 0.95 |
| 009 | 20.84 | 0.46 |

Table 1 shows the results of EDX analysis at the measuring points 006, 007 and 009 in Fig. 23. The Zn concentration on the sidewall of the back face electrode layer separation grooves is 2.5 atomic %, 0.95 atomic % and 0.46 atomic % at the measuring point 006, the measuring point 007 and the measuring point 009, respectively. The presence of the residue E derived from the damage of the transparent electrode layer 12 causes Zn to be detected on the wall surface of the back face electrode layer separation grooves; however, Zn was detected by 2.5 atomic % at the maximum in Example 9. Accordingly, it is understood that the present invention restrains Zn-containing residue from occurring on the wall surface of the back face electrode layer separation grooves. The measuring point 008 in Fig. 23 corresponds to the position in the Si semiconductor layer.

(Example 10)

An integrated type thin film solar cell similar to Example 9 was fabricated also in Example 10. That is, an integrated type thin film solar cell of Example 10 was different from Example 9 only in forming the back face electrode layer separation grooves by the first laser beam only. The back face electrode layer separation grooves 9040 in Example 10 were formed in such a manner that the elliptic pits 9041 with the maximum length in a groove width direction of 70 $\mu$m and the maximum length in a groove longer direction of 50 $\mu$m range at a predetermined pitch. The local maximum width of the groove was 70 $\mu$m. When this integrated type thin film solar cell fabricated in Example 10 was subjected to a reverse bias treatment, two cells were rejected.

After this reverse bias treatment, when the output characteristics of the integrated type thin film solar cell of Example 10 were measured in the same manner as the case of Example 9, Voc was 1.325 V, Jsc was 13.57 mA/cm$^2$, FF was 0.729 and Eff was 13.11%. When the presence or absence of leak current and a short circuit in Example 10 was inspected by a Vfl measurement in the same manner as the case of Example 9, two cells offering large leak current existed in all of the 50 rows of photoelectric conversion cells. The integrated type thin film solar cell was fabricated by 100 pieces in Example 10, and a yield of the integrated type thin film solar cell having an Eff of 12% or more was 78%.

In Example 10, the photoelectric conversion cells having Vfl of less than 0.8 V were cut out to perform photographing and EDX analysis of a cross-sectional SEM image in the same manner as the case of Example 9. Fig. 24 shows a cross-sectional SEM image in Example 10, and a large residue (a position of the measuring point 001) is recognized on the wall surface of the back face electrode layer separation grooves.

[Table 2]

| Measuring point | O (atomic %) | Zn (atomic %) |
|---|---|---|
| 001 | 69.14 | 21.44 |
| 002 | 59.26 | 13.79 |
| 004 | 23.43 | 1.25 |

Table 2 shows the results of EDX analysis at the measuring points 001, 002 and 004 in Fig. 24. The Zn concentration on the sidewall of the back face electrode layer separation grooves is 21.44 atomic %, 13.79 atomic % and 1.25 atomic % at the measuring point 001, the measuring point 002 and the measuring point 004, respectively. That is, in Example 10, Zn of 21.44 atomic % at the maximum was detected on the wall surface of the back face electrode layer separation grooves. Thus, it is understood that a Zn-containing residue derived from the transparent electrode layer damage due to a laser beam is attached to the wall surface of the back face electrode layer separation grooves contacting with the photoelectric conversion cells offering low Vfl and large leak current in Example 10. It is understood that a substance degenerating from ZnO as a material for the transparent electrode layer is attached as the residue E for the reason that the atomic concentration ratio of Zn and O is not 1: 1 in the measuring points 001 and 002. The measuring point 003 in Fig. 24 corresponds to the position in the Si semiconductor layer.

Voc and FF are decreased to lower Eff in Example 10 as compared with Example 9. More specifically, as high Eff as 13.50% is obtained in Example 9, but Eff is lowered to 13.11% in Example 10. In other words, the second pit row in addition to the first kind pit row was partially formed in the back face electrode layer separation grooves in Example 9, so that Jsc is somewhat decreased by generating area loss in Example 9 as compared with Example 10, and it is understood that the increasing rate of Voc and FF is so high as to improve Eff. The yield of the integrated type thin film solar cell having an Eff of 12% or more is lowered to 78% as described above in Example 10 as compared with 94% in Example 9.

(Example 11)

An integrated type thin film solar cell similar to Example 9 was fabricated also in Example 11. That is, Example 11 was different from Example 9 only in irradiating the first laser beam and the second laser beam on all of the plural back face electrode layer separation grooves. When the integrated type thin film solar cell with the back face electrode layer separation grooves formed by using the first laser beam in Example 11 was subjected to a reverse bias treatment, three cells were rejected.

After this reverse bias treatment, when the output characteristics of the integrated type thin film solar cell of Example 11 were measured in the same manner as the case of Example 9, Voc was 1.300 V, Jsc was 13.71 mA/cm$^2$, FF was 0.712 and Eff was 12.69%.

Then, the second laser beam was irradiated on all of the plural back face electrode layer separation grooves. That is, both the first laser beam and the second laser beam in Example 9 were irradiated on all of the back face electrode layer separation grooves in Example 11. Then, when the reverse bias treatment was performed again, six cells were rejected.

After irradiating the second laser beam, when the output characteristics of the integrated type thin film solar cell of Example 11 were measured in the same manner as the case of Example 9, Voc was 1.286 V, Jsc was 13.58 mA/cm$^2$, FF was 0.665 and Eff was 11.60%.

The integrated type thin film solar cell was fabricated by 100 pieces in Example 11, and a yield of the integrated type thin film solar cell having an Eff of 12% or more was 53%.

As compared with Examples 9 and 10, it is understood that Voc, Jsc and FF are decreased in Example 11 to decrease Eff to 11. 60% lower than Example 10. The yield of the integrated type thin film solar cell is also decreased in Example 11 as compared with Example 10. That is, it is understood that an Eff and a yield in Example 11, in which the second laser beam is additionally irradiated on all of the back face electrode layer separation grooves, are decreased as compared with Example 10, in which all of the back face electrode layer separation grooves are formed by using the first laser beam only.

(Example 12)

An integrated type thin film solar cell similar to Example 9 was fabricated also in Example 12. Specifically, Example 12 was different from Example 9 only in that the first laser beam and the second laser beam were irradiated on all of the plural back face electrode layer separation grooves, and the energy density of the first laser beam was increased to 0.9 J/cm$^2$. That is, the influence on current leak in the back face electrode layer separation grooves by increasing the energy density of the first laser beam was inspected in Example 12. Then, also in Example 12, an output voltage (Vfl) of each cell was measured under the irradiation of fluorescent light in the same manner as the case of Example 9.

The graph of Fig. 25 shows the increase (Vfl$_2$-Vfl$_1$) of an output voltage with respect to Vfl$_1$ for all of the 50 rows of cells when an output voltage of a cell under the fluorescent light irradiation after forming the back face electrode layer separation grooves by irradiating the first laser beam only and an output voltage of a cell under the fluorescent light irradiation after additionally irradiating the second laser beam are determined at Vfl$_1$ and Vfl$_2$, respectively. In this graph, (Vfl$_2$-Vfl$_1$) is decreased approximately monotonously in accordance with the increase of Vfl$_1$ of the cell and becomes a negative value in Vfl$_1$ of approximately 0.6 V or more.

It is understood from the graph of Fig. 25 that an output voltage Vfl is decreased to the contrary by additional irradiation of the second laser beam with regard to the cell having sufficiently large Vfl after forming the back face electrode layer separation grooves by irradiating the first laser beam only. That is, when favorable back face electrode layer separation grooves are formed by irradiating the first laser beam, it is conceived that additional irradiation of the second laser beam should not be performed. On the contrary, (Vfl$_2$-Vfl$_1$) becomes a positive value in the cell having a Vfl$_1$ of less than approximately 0.6 V, so that it is conceived that current leak in the back face electrode layer separation grooves is restrained by additional irradiation of the second laser beam. In particular, (Vfl$_2$-Vfl$_1$) always becomes a positive value even in consideration of a range of dispersion with regard to the cell having Vfl$_1$ of approximately 0.3 V or less; therefore, it is understood that additional irradiation of the second laser beam is desirable for the back face electrode layer separation grooves contacting with the cell having Vfl$_1$ of approximately 0.3 V or less.

(Comparative Example 5)

An integrated type thin film solar cell similar to Example 9 was fabricated also in Comparative Example 5. More specifically, Comparative Example 5 was different from Example 9 only in that the foundation layer 112 was omitted, the transparent electrode layer 12 was formed out of SnO$_2$, and the p-type layer 21 was formed out of only a p-type amorphous silicon carbide layer having a thickness of 15 nm (refer to Fig. 6).

A commercial glass substrate and an $SnO_2$ electrode layer thereon were used as the transparent insulating substrate 11 and the transparent electrode layer 12 thereon. The thickness of the $SnO_2$ electrode layer was approximately 0.8 μm, the sheet resistance was 13.1 Ω/□, and the haze ratio with regard to light transmission of the glass substrate and the $SnO_2$ electrode layer was 14.7%.

The first kind pit row 9044 similar to the case of Example 9 was obtained by irradiating the first laser beam also in forming the back face electrode layer separation grooves in Comparative Example 5. Thereafter, reverse bias treatment was performed, and one cell was rejected by reason of leak current over an allowable value. Then, the second laser beam was additionally irradiated only on the back face electrode layer separation grooves contacting with the rejected cell. The second kind pit row 9046 similar to the case of Example 9 was obtained also in Comparative Example 5 by irradiating this second laser beam.

When the rejected cell after irradiating the first laser beam was subjected to the reverse bias treatment again after additionally irradiating the second laser beam, leak current became an allowable value or less and the cell was determined to be acceptable.

When the output characteristics of the obtained integrated type thin film solar cell of Comparative Example 5 were measured in the same manner as the case of Example 9, Voc was 1.380 V, Jsc was 13.14 mA/cm$^2$, FF was 0.711 and Eff was 12.89%. When the presence or absence of leak current and a short circuit was inspected by a Vfl measurement in the same manner as the case of Example 9, no cells offering large leak current in Comparative Example 5 existed in all of the 50 rows of photoelectric conversion cells.

In comparison between Comparative Example 5 and Example 9, Jsc and FF are decreased to lower Eff, resulting from the shift of a material for the transparent electrode layer 12 from ZnO to $SnO_2$. However, leak current and a short circuit in accordance with the formation of the back face electrode layer separation grooves may be restrained also in the case of using $SnO_2$ for the transparent electrode layer 12, and it is understood that the present invention is effective regardless of a material for the transparent electrode layer 12.

(Example 13)

An integrated type thin film solar cell similar to Example 10 was fabricated in Example 13. More specifically, Example 13 was different from Example 10 only in that the major axis length of the elliptic irradiated region M of the first laser beam in forming the back face electrode layer separation grooves was modified from 70 μm to 90 μm, and resin sealing was omitted. Each of the back face electrode layer separation groove was formed by a range of lateral elliptic pits with a minor axis length of 50 μm and a major axis length of 90 μm range to form, and the local maximum width of the grooves was 90 μm.

In Example 13, when the reverse bias treatment was performed after forming the back face electrode layer separation grooves by irradiating the first laser beam, four cells were rejected.

When the output characteristics of the obtained integrated type thin film solar cell of Example 13 were measured in the same manner as the case of Example 9, Voc was 1.306 V, Jsc was 13.47 mA/cm$^2$, FF was 0.726 and Eff was 12.77%.

When the presence or absence of leak current and a short circuit in Example 13 was inspected by a Vfl measurement in the same manner as the case of Example 9, four cells offering large leak current existed in all of the 50 rows of cells. In particular, one cell among the four cells showed Vfl of 0 V and was completely short-circuited.

Then, when the back face electrode layer separation grooves of the short-circuited cell was observed by a microscope, 'pit dislocation' such that a pit lacks was found by one place as shown in Fig. 18. In this case, it is understood that a short circuit is caused between the cells on both sides of the back face electrode layer separation grooves. It is conceived that this pit dislocation was caused for the reason that the laser beam was biased, scattered or shielded by an attachment of a foreign matter such as dust in a path of the laser beam.

(Example 14)

In Example 14 of the present invention, the second laser beam was further irradiated additionally only with the back face electrode layer separation grooves contacting with the four rejected cells in the integrated type thin film solar cell of Example 13.

The center of an irradiated region N of a lateral elliptic shape with a minor axis length of 50 μm and a major axis length of 90 μm was displaced by approximately 45 μm from the center of an irradiated region M in a direction moving away from the nearest semiconductor layer separation grooves 905 thereto so that the irradiated region N of the second laser beam overlaps partially with the irradiated region M of the first laser beam. Thus, the local maximum length Wn in a groove width direction of the formed second kind pits was contracted to 90 μm by overlap with the first kind pit row. Then, the local maximum width Wo of the back face electrode layer separation grooves was 135 μm and Wo/Wm was 1.5.

When the four rejected cells before irradiating the second laser beam were subjected to a reverse bias treatment again after irradiating the second laser beam, leak current in any of the four cells became an allowable value or less and any of the cells were determined to be acceptable.

The output characteristics of the obtained integrated type thin film solar cell of Example 14 were measured in the same manner as the case of Example 9, Voc was 1.334 V, Jsc was 13.35 mA/cm$^2$, FF was 0.743 and Eff of 13.23%. When the presence or absence of leak current and a short circuit was inspected by a Vfl measurement in the same manner as the case of Example 9, no cells showing large leak current in Example 14 existed in all of the 50 rows of cells.

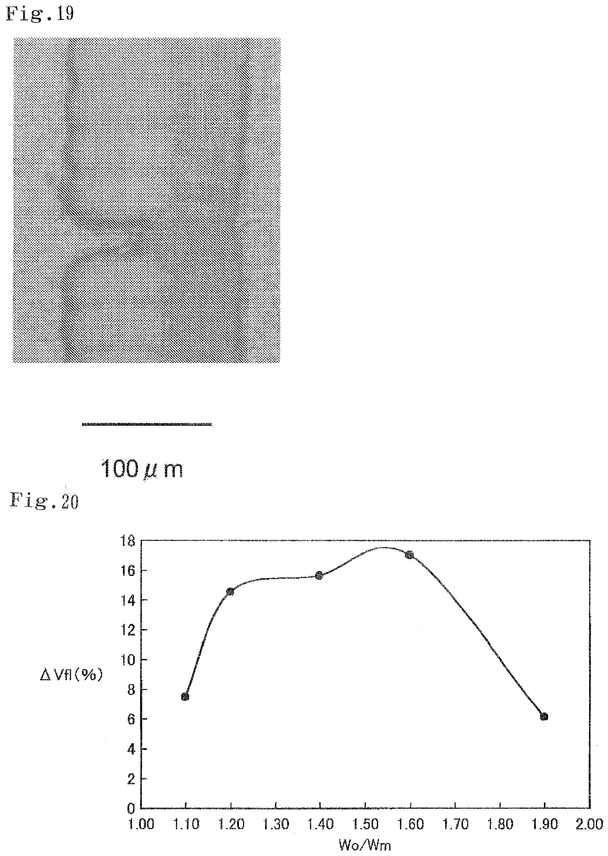

The microphotograph of Fig. 19 shows a state after irradiating the second laser beam in Example 14 with regard to the pit dislocation position in the back face electrode layer separation grooves of Example 13. In this Fig. 19, it is understood that an uncut portion of the back face electrode layer resulting from the pit dislocation in the first kind pit row is separated by the second kind pit row formed by additionally irradiating the second laser beam to repair a short circuit in a groove width direction. Further, as compared with Example 13, it is understood that Voc and FF are increased in Example 14 to improve Eff. That is, it is understood that the present invention is effective for restraint of leak and a short circuit of the back face electrode layer separation grooves in a depth direction as well as restraint of leak and a short circuit in a groove width direction.

(Example 15)

A plurality of integrated type thin film solar cells similar to Example 9 were fabricated in Example 15 of the present invention to examine the desirable conditions of the ratio Wo/Wm of the local maximum length Wo of the back face electrode layer separation grooves in a width direction to the local maximum length Wm of the first kind pit row in a width direction. More specifically, a plurality of integrated type thin film solar cells similar to Example 9 were fabricated in Example 15 to select a cell offering large leak current and a Vfl$_1$ of less than 0.6 V by measuring Vfl in the same manner as the case of Example 9. With regard to the back face electrode layer separation grooves contacting with the selected photoelectric conversion cells, the second laser beam was additionally irradiated while adjusting the irradiated region N so that Wo/Wm became various values to thereafter measure the increasing rate of Vfl, namely, $\Delta$Vfl$=100\times$(Vfl$_2$-Vfl$_1$)/Vfl$_1$ [%].

That is, a plurality of integrated type thin film solar cells in Example 15 were different from Example 9 only in that Wo/Wm is variously modified in the back face electrode layer separation grooves on which the second laser beam was additionally irradiated. In the formed back face electrode layer separation grooves, the local maximum length of the groove width in a region on which only the first laser beam was irradiated is approximately equal to the local maximum length Wm of the width of the first kind pit row, and the local maximum length of the groove width in a region on which the second laser beam as well as the first laser beam was additionally irradiated is equal to Wo.

Fig. 20 is a graph showing the influence of Wo/Wm on $\Delta$Vfl. Each of the measuring points in this graph denotes an average value of the measurement sampling number of 3 or more. In the graph of Fig. 20, $\Delta$Vfl is increased in accordance with an increase in Wo/Wm, has the local maximum value in the vicinity of Wo/Wm=1.6, and is decreased in accordance with a further increase in Wo/Wm. That is, it is desirable for obtaining as high $\Delta$Vfl as 10% or more that Wo/Wm is set within the range of 1.15 or more and 1.8 or less. It is more desirable for obtaining $\Delta$Vfl of 14% or more that Wo/Wm is set within the range of 1.2 or more and 1.7 or less.

(Example 16)

A plurality of integrated type thin film solar cells similar to Example 9 were fabricated in Example 16 of the present invention to examine the desirable conditions of the ratio E2/E1 [%] of the energy density E2 of the second laser beam to the energy density E1 of the first laser beam in forming the back face electrode layer separation grooves. More specifically, Example 16 was different from Example 15 only in that $\Delta$Vfl was measured while variously changing E2/E1 in a state of fixing Wo/Wm at 1.6.

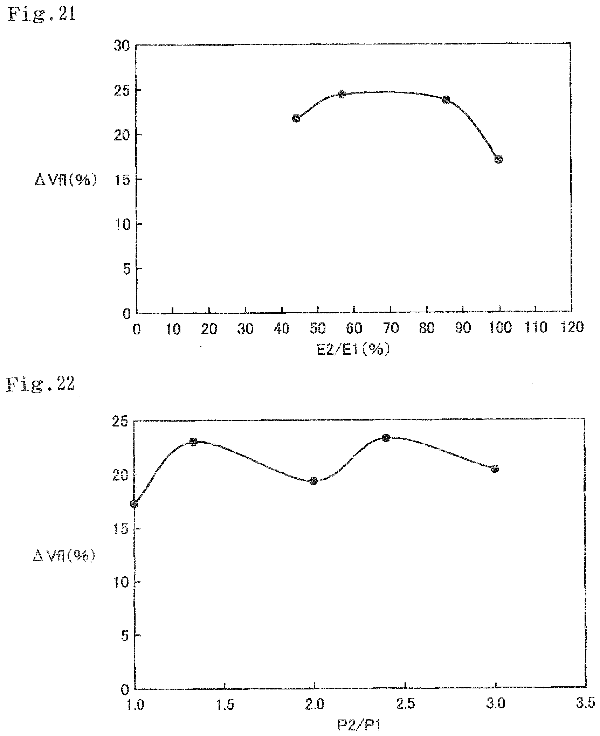

Fig. 21 is a graph showing the influence of E2/E1 on $\Delta$Vfl. Each of the measuring points in this graph also denotes an average value of the measurement sampling number of 3 or more. In the graph of Fig. 21, $\Delta$Vfl is increased in accordance with a decrease in E2/E1 from 100%. This signifies that it is desirable to decrease E2 as compared with E1. It is desirable for obtaining $\Delta$Vfl of 20% or more that E2/E1 is set within the range of 44% or more and 95% or less.

(Example 17)

A plurality of integrated type thin film solar cells similar to Example 9 were fabricated in Example 17 of the present invention to examine the desirable conditions of the ratio P2/P1 of the irradiation number (pulse number) P2 of the second laser beam to the irradiation number P1 of the first laser beam per unit length of the back face electrode layer separation grooves. More specifically, Example 17 was different from Example 15 only in that $\Delta$Vfl was measured while variously changing P2/P1 in a state of fixing Wo/Wm at 1.6. The relative scanning speed of the second laser beam to the back face electrode layer was changed for changing P2/P1. More specifically, the scanning speed of the second laser beam was variously decreased as compared with the first laser beam.

Fig. 22 is a graph showing the influence of P2/P1 on ΔVfl. Each of the measuring points in this graph also denotes an average value of the measurement sampling number of 3 or more. As is understood from the graph of Fig. 22, setting P2/P1 to more than 1 allows favorable ΔVfl. That is, it is desirable that the irradiation number of the second laser beam per unit length is set to more than that of the first laser beam. It is conceived that setting P2/P1 to more than 1 increases a probability that a defect such as a residue and an uncut portion in the back face electrode layer separation grooves may be restrained from occurring. When P2/P1 is more than 1, it is needless to say that the second kind pit number formed by the second laser beam is increased as compared with the first kind pit number formed by the first laser beam per unit length.

As shown in Fig. 22, ΔVfl is increased while repeating a local maximum value and a local minimum value when P2/P1 is increased in a range of more than 1. More specifically, ΔVfl denotes a local minimum value when a value of P2/P1 is an integer. That is, the number of the second kind pits is an integral multiple of the number of the first kind pit per unit length.

The reason why ΔVfl becomes a local minimum value when P2/P1 is an integer may be conceived as follows. That is, a narrow portion, in which the width of the first kind pit row becomes a local minimum value, is formed in the boundary between the adjacent first kind pits formed by the first laser beam, in which portion a defect such as a residue and an uncut portion are easily caused. When P2/P1 is an integer, a narrow portion in the boundary between the adjacent second kind pits formed by the second laser beam may be in the same position as a narrow portion of the first kind pit row. Accordingly, a position in which a residue exists easily in irradiating the first laser beam corresponds to a position in which a residue exists easily in irradiating the second laser beam, and it is conceived that the residue in the back face electrode layer separation grooves is not completely removed. In other words, it is conceived that the residue E may be removed more effectively by avoiding P2/P1 of an integer.

In Example 17, the scanning speed of the second laser beam was decreased for modifying P2/P1, and it is needless to say that the same effect is obtained even though the pulse frequency of the second laser beam is increased instead.

(Example 18)

An integrated type thin film solar cell similar to Example 9 was fabricated in Example 18 of the present invention. More specifically, Example 18 was different from Example 9 only in that Wo/Wm=1. 6, E2/E1=60% and P2/P1=1. 33 were determined as the desirable conditions measured in Examples 15 to 17.

In Example 18, the reverse bias treatment was performed after forming the back face electrode layer separation grooves by irradiating only the first laser beam, and three cells were rejected. When the second laser beam was additionally irradiated on the back face electrode layer separation grooves contacting with the three cells so as to satisfy the above-mentioned optimum conditions, all of the three cells passed in the reverse bias treatment again. In this case, the local maximum width of the back face electrode layer separation grooves was 112 μm.

When the output characteristics of the obtained integrated type thin film solar cell of Example 18 were measured in the same manner as the case of Example 9, Voc was 1.378 V, Jsc was 13.39 mA/cm$^2$, FF was 0.742 and Eff was 13.69%. When the presence or absence of leak current and a short circuit was inspected by a Vfl measurement in the same manner as the case of Example 9, no cells showing large leak current in Example 18 existed in all of the 50 rows of cells.

That is, in Example 18, the optimization of Wo/Wm, E2/E1 and P2/P1 increases Voc and FF to improve Eff, whereby as high Eff as 13.69% is obtained as compared with Example 9.

(Example 19)

An integrated type thin film solar cell similar to Example 9 was fabricated in Example 19. More specifically, Example 19 was different from Example 9 only in that the center of an irradiated region N was displaced by approximately 80 μm from the center of an irradiated region M in a direction moving away from the nearest semiconductor layer separation grooves thereto so that the irradiated region N of the second laser beam does not overlap with the irradiated region M of the first laser beam. That is, in Example 19, a gap of 10 μm or more was caused between the first kind pit row and the second kind pit row.

In Example 19, when the reverse bias treatment was performed after forming the back face electrode layer separation grooves by only the first laser beam, and three cells were rejected. When the second laser beam was additionally irradiated on the back face electrode layer separation grooves contacting with the three cells, all of the three cells were still rejected in the reverse bias treatment again thereafter.

When the output characteristics of the obtained integrated type thin film solar cell of Example 19 were measured in the same manner as the case of Example 9, Voc was 1.320 V, Jsc was 13.41 mA/cm$^2$, FF was 0.712 and Eff was 12.61%. When the presence or absence of leak current and a short circuit was inspected by a Vfl measurement in the same manner as the case of Example 9, three cells showing large leak current in Example 19 existed in all of the 50 rows of cells.

As is clarified from the above, in Example 19 such that the region M does not overlap with the region N at all, Eff is decreased as compared with Example 10 as well as in Example 9. The reason therefor is conceived to be that the region M does not overlap with the region N in Example 19, so that the residue E as shown in an elliptic region 7P in Fig. 7 may not be removed. Although the second laser beam was additionally irradiated in Example 19, it is conceived that, due to the reason above, the additional irradiation causes no effects of restraining current leak in a groove depth direction and may not improve Voc and FF. The overall width of the first kind pit row, the overall width of the second kind pit row, and a gap between the first kind pit row and the second kind pit row do not contribute as a generating region, so that it is conceived that a decrease in Jsc due to area loss and a decrease in FF due to an increase in resistance loss are caused to consequently decrease Eff.

It will be easily understood to those skilled in the art that a p-type layer and an n-type layer may be reversed with each other in various examples as described above.

INDUSTRIAL APPLICABILITY

As described above, the present invention may improve a photoelectric conversion efficiency, cost and yield of an integrated type thin film solar cell including a ZnO transparent electrode layer.

**Claims**

1. A method for fabricating an integrated type thin film solar cell, wherein a transparent electrode layer (12), a semiconductor layer (20) including a photoelectric conversion unit (2,3), and a back face electrode layer (4) sequentially deposited on a transparent insulating substrate (11), the transparent electrode layer (12) being divided by a plurality of transparent electrode layer separation grooves (903), the semiconductor layer (20) being divided by a plurality of semiconductor layer separation grooves (905) and a plurality of back face electrode layer separation grooves (904, 9040), and the back face electrode layer (4) being divided by the back face electrode layer separation grooves (904, 9040),
the transparent electrode layer separation grooves (903), the semiconductor layer separation grooves (905) and the back face electrode layer separation grooves (904, 9040) are linear and parallel to each other, so as to form a plurality of photoelectric conversion cells, the plurality of photoelectric conversion cells being electrically connected to each other in series through metallic material embedded in the semiconductor layer separation grooves (905);
**characterized in that**:

the transparent electrode layer (12) is formed out of zinc oxide and is formed by a low-pressure CVD method;
at least a part of the back face electrode layer separation grooves (904, 9040) are composed of a range of pits (9043, 9045) in the same shape formed at a predetermined pitch, that a maximum length W in a width direction of the grooves (904, 9040) in each of the pits is larger than a maximum length L in a longitudinal direction of the grooves (904, 9040);
each of the pits is formed by pulse irradiation of a laser beam and an energy density of the laser beam for forming the pits included in the back face electrode layer separation grooves (904, 9040) is within the range from 1.1 times or more to 2 times or less of a minimum energy density capable of cutting the back face electrode layer (4).

2. The method for fabricating the integrated type thin film solar cell according to claim 1, wherein W/L is within the range from 1.25 or more to 7.2 or less.

3. The method for fabricating the integrated type thin film solar cell according to claim 1 or 2, wherein a maximum length d such that the adjacent pits overlap in a longitudinal direction of the grooves is within the range from 6% or more to 33% or less of L.

4. The method for fabricating the integrated type thin film solar cell according to any one of claims 1 to 3, wherein a plane shape of each of the pits is elliptic.

5. The method for fabricating the integrated type thin film solar cell according to any one of claims 1 to 4, wherein a

# EP 2 169 724 B1

plane area of each of the pits is within the range from $3\times10^{-10}$ m$^2$ or more to $4\times10^{-8}$ m$^2$ or less.

6. The method for fabricating the integrated type thin film solar cell according to any one of claims 1 to 5, comprising:

a step of irradiating a first laser beam on the whole region for forming a plurality of the back face electrode layer separation grooves (9040); and
a step of additionally irradiating a second laser beam on at least a part of each of the grooves of a partial number selected from all of the back face electrode layer separation grooves (9040);
wherein the center of an irradiated region (N) is displaced from the center of an irradiated region (M) in a direction moving away from the nearest semiconductor layer separation groove thereto so that the irradiated region (N) of the second laser beam overlaps partially with the irradiated region (M) of the first laser beam.

7. The method for fabricating the integrated type thin film solar cell according to claim 6, wherein a ratio of a local maximum value of a groove width in a portion formed by additionally irradiating the second laser beam to a local maximum value of a groove width in a portion formed by only irradiating the first laser beam is within the range from 1.15 or more to 1.8 or less in the back face electrode layer separation grooves (9040).

8. The method for fabricating the integrated type thin film solar cell according to claim 6 or 7, wherein the energy density of the second laser beam is low as compared with the first laser beam.

9. The method for fabricating the integrated type thin film solar cell according to any one of claims 6 to 8, wherein the first and the second laser beams are irradiated in a pulsed state, and the number of irradiated pulses of the second laser beam is large as compared with the first laser beam with regard to a unit length of the back face electrode layer separation grooves (9040).

10. The method for fabricating the integrated type thin film solar cell according to any one of claims 1 to 5, wherein:

at least a part of each of the grooves of a partial number among a plurality of the back face electrode layer separation grooves (9040) are composed of a row of first kind pits (9044) in the same shape ranging at a first pitch and a row of second kind pits (9046) in the same shape ranging at a second pitch; the row of first kind pits and the row of second kind pits overlap partially in a groove width direction;
a local maximum length (Wn) of the row of second kind pits in a groove width direction is small as compared with a local maximum length (Wm) of the row of first kind pits in a groove width direction; and
a center line of the row of second kind pits is displaced from a center line of the row of first kind pits in a direction moving away from the nearest semiconductor layer separation groove thereto.

11. The method for fabricating the integrated type thin film solar cell according to claim 10, wherein a ratio (Wo/Wm) of a local maximum length (Wo) of a groove width composed of both the row of first kind pits and the row of second kind pits to a local maximum length (Wm) of the row of first kind pits in a groove width direction is 1.15 or more and 1.8 or less.

12. The method for fabricating the integrated type thin film solar cell according to claim 10 or 11, wherein the second pitch of the row of second kind pits is short as compared with the first pitch of the row of first kind pits.

**Patentansprüche**

1. Verfahren zum Herstellen einer integrierten Dünnschichtsolarzelle, wobei eine transparente Elektrodenschicht (12), eine Halbleiterschicht (20), die eine photoelektrische Umwandlungseinheit (2,3) aufweist, und eine Rückseitenelektrodenschicht (4) aufeinanderfolgend auf einem transparenten isolierenden Substrat (11) abgeschieden werden, wobei die transparente Elektrodenschicht (12) durch eine Vielzahl von Trennrillen (903) der transparenten Elektrodenschicht unterteilt ist, die Halbleiterschicht (20) durch eine Vielzahl von Trennrillen (905) der Halbleiterschicht und eine Vielzahl von Trennrillen (904, 9040) der Rückseitenelektrodenschicht unterteilt ist, und die Rückseitenelektrodenschicht (4) durch die Trennrillen (904, 9040) der Rückseitenelektrodenschicht unterteilt ist,
die Trennrillen (903) der transparenten Elektrodenschicht, die Trennrillen (905) der Halbleiterschicht und die Trennrillen (904, 9040) der Rückseitenelektrodenschicht linear und parallel zueinander sind, um eine Vielzahl von photoelektrischen Umwandlungszellen zu bilden, wobei die Vielzahl der photoelektrischen Umwandlungszellen durch ein metallisches Material miteinander elektrisch in Reihe geschaltet sind, das in die Trennrillen (905) der Halblei-

32

terschicht eingebettet ist;
**dadurch gekennzeichnet, dass**:

die transparente Elektrodenschicht (12) aus Zinkoxid ausgebildet ist und durch ein Niederdruck-CVD-Verfahren gebildet wird;
mindestens ein Teil der Trennrillen (904, 9040) der Rückseitenelektrodenschicht aus einer Reihe von Vertiefungen (9043, 9045) in derselben Form zusammengesetzt ist, die in einem vorgegebenen Zwischenraum ausgebildet sind, dass eine maximale Länge W in eine Breitenrichtung der Rillen (904, 9040) in jeder der Vertiefungen größer als eine maximale Länge L in eine Längsrichtung der Rillen (904, 9040) ist;
jede der Vertiefungen durch Impulsbestrahlung eines Laserstrahls gebildet wird und eine Energiedichte des Laserstrahls zum Bilden der Vertiefungen, die in den Trennrillen (904, 9040) der Rückseitenelektrodenschicht enthalten sind, innerhalb des Bereichs des 1,1-fachen oder mehr bis zum 2-fachen oder weniger einer minimalen Energiedichte liegt, die zum Schneiden der Rückseitenelektrodenschicht (4) fähig ist.

2. Verfahren zum Herstellen der integrierten Dünnschichtsolarzelle nach Anspruch 1, wobei W/L innerhalb des Bereichs von 1,25 oder mehr bis 7,2 oder weniger liegt.

3. Verfahren zum Herstellen der integrierten Dünnschichtsolarzelle nach Anspruch 1 oder 2, wobei eine maximale Länge d, so dass sich die benachbarten Vertiefungen in eine Längsrichtung der Rillen überlappen, innerhalb des Bereichs von 6% oder mehr bis 33% oder weniger von L liegt.

4. Verfahren zum Herstellen der integrierten Dünnschichtsolarzelle nach einem der Ansprüche 1 bis 3, wobei eine ebene Form von jeder der Vertiefungen elliptisch ist.

5. Verfahren zum Herstellen der integrierten Dünnschichtsolarzelle nach einem der Ansprüche 1 bis 4, wobei eine ebene Fläche von jeder der Vertiefungen innerhalb des Bereichs von $3\times10^{-10}$ m$^2$ oder mehr bis $4\times10^{-8}$ m$^2$ oder weniger liegt.

6. Verfahren zum Herstellen der integrierten Dünnschichtsolarzelle nach einem der Ansprüche 1 bis 5, das aufweist:

einen Schritt des Einstrahlens eines ersten Laserstrahls auf die gesamte Region zum Bilden einer Vielzahl der Trennrillen (9040) der Rückseitenelektrodenschicht; und
einen Schritt des zusätzlichen Einstrahlens eines zweiten Laserstrahls auf mindestens einen Teil der Rillen einer Teilanzahl, die aus allen Trennrillen (9040) der Rückseitenelektrodenschicht ausgewählt ist;
wobei die Mitte einer bestrahlten Region (N) von der Mitte einer bestrahlten Region (M) in eine Richtung versetzt ist, die sich von der dazu nächstgelegenen Trennrille der Halbleiterschicht weg bewegt, so dass sich die bestrahlte Region (N) des zweiten Laserstrahls teilweise mit der bestrahlten Region (M) des ersten Laserstrahls überlappt.

7. Verfahren zum Herstellen der integrierten Dünnschichtsolarzelle nach Anspruch 6, wobei ein Verhältnis eines lokalen Maximalwerts einer Rillenbreite in einem Abschnitt, der durch zusätzliches Einstrahlen des zweiten Laserstrahls gebildet wird, zu einem lokalen Maximalwert einer Rillenbreite in einem Abschnitt, der nur durch Einstrahlen des ersten Laserstrahls gebildet wird, innerhalb des Bereichs von 1,15 oder mehr bis 1,8 oder weniger in den Trennrillen (9040) der Rückseitenelektrodenschicht liegt.

8. Verfahren zum Herstellen der integrierten Dünnschichtsolarzelle nach Anspruch 6 oder 7, wobei die Energiedichte des zweiten Laserstrahls im Vergleich zum ersten Laserstrahl niedrig ist.

9. Verfahren zum Herstellen der integrierten Dünnschichtsolarzelle nach einem der Ansprüche 6 bis 8, wobei der erste und der zweite Laserstrahl in einem gepulsten Zustand eingestrahlt werden, und die Anzahl der eingestrahlten Impulse des zweiten Laserstrahls im Vergleich zum ersten Laserstrahl hinsichtlich einer Längeneinheit der Trennrillen (9040) der Rückseitenelektrodenschicht groß ist.

10. Verfahren zum Herstellen der integrierten Dünnschichtsolarzelle nach einem der Ansprüche 1 bis 5, wobei:

mindestens ein Teil von jeder der Rillen einer Teilanzahl unter einer Vielzahl der Trennrillen (9040) der Rückseitenelektrodenschicht aus einer Reihe von Vertiefungen (9044) einer ersten Art in derselben Form, die sich mit einem ersten Zwischenraum erstrecken, und aus einer Reihe von Vertiefungen (9046) einer zweiten Art in derselben Form zusammengesetzt ist, die sich mit einem zweiten Zwischenraum erstrecken;

sich die Reihe der Vertiefungen der ersten Art und die Reihe der Vertiefungen der zweiten Art teilweise in eine Rillenbreitenrichtung überlappen;

eine lokale maximale Länge (Wn) der Reihe der Vertiefungen der zweiten Art in eine Rillenbreitenrichtung im Vergleich zu einer lokalen maximalen Länge (Wm) der Reihe der Vertiefungen der ersten Art in eine Rillenbreitenrichtung klein ist; und

eine Mittellinie der Reihe der Vertiefungen der zweiten Art von einer Mittellinie der Reihe der Vertiefungen der ersten Art in eine Richtung versetzt ist, die sich von der dazu nächstgelegenen Trennrille der Halbleiterschicht weg bewegt

11. Verfahren zum Herstellen der integrierten Dünnschichtsolarzelle nach Anspruch 10, wobei ein Verhältnis (Wo/Wm) einer lokalen maximalen Länge (Wo) einer Rillenbreite, die sowohl aus der Reihe der Vertiefungen der ersten Art als auch der Reihe der Vertiefungen der zweiten Art zusammengesetzt ist, zu einer lokalen maximalen Länge (Wm) der Reihe der Vertiefungen der ersten Art in eine Rillenbreitenrichtung 1,15 oder mehr und 1,8 oder weniger beträgt.

12. Verfahren zum Herstellen der integrierten Dünnschichtsolarzelle nach Anspruch 10 oder 11, wobei der zweite Zwischenraum der Reihe der Vertiefungen der zweiten Art im Vergleich zum ersten Zwischenraum der Reihe der Vertiefungen der ersten Art kurz ist.

**Revendications**

1. Procédé de fabrication d'une cellule solaire à couche mince intégrée, où une couche d'électrode transparente (12), une couche semi-conductrice (20) comprenant une unité de conversion photoélectrique (2, 3) et une couche d'électrode arrière (4) déposée séquentiellement sur un substrat isolant transparent (11), la couche d'électrode transparente (12) étant divisée par une pluralité de rainures de séparation (903) de couche d'électrode transparente, la couche semi-conductrice (20) étant divisée par une pluralité de rainures de séparation (905) de couche semi-conductrice et une pluralité de rainures de séparation (904, 9040) de couche d'électrode arrière, et la couche d'électrode arrière (4) étant divisée par les rainures de séparation (904, 9040) de couche d'électrode arrière, les rainures de séparation (903) de couche d'électrode transparente, les rainures de séparation (905) de couche semi-conductrice et les rainures de séparation (904, 9040) de couche d'électrode arrière étant linéaires et parallèles entre elles, de manière à former une pluralité de cellules de conversion photoélectrique, les cellules de la pluralité de cellules de conversion photoélectrique étant électriquement connectées en série entre elles par un matériau métallique incorporé aux rainures de séparation (905) de couche semi-conductrice ;

   **caractérisé en ce que** :

   la couche d'électrode transparente (12) est constituée d'oxyde de zinc et est formée au moyen d'un procédé de dépôt en phase vapeur sous basse pression ;
   au moins une partie des rainures de séparation (904, 9040) de couche d'électrode arrière est constituée d'une chaîne de cuvettes (9043, 9045) de forme identique ayant un premier pas défini, **en ce qu'**une longueur maximale W dans le sens de la largeur des rainures (904, 9040) dans chacune des cuvettes est supérieure à une longueur maximale L dans le sens de la longueur des rainures (904, 9040) ;
   chacune des cuvettes est formée par irradiation d'impulsions d'un faisceau laser, et une densité d'énergie du faisceau laser pour former les cuvettes comprises dans les rainures de séparation (904, 9040) de couche d'électrode arrière est comprise entre 1,1 fois et 2 fois un minimum de densité d'énergie apte à découper la couche d'électrode arrière (4).

2. Procédé de fabrication de la cellule solaire à couche mince intégrée selon la revendication 1, où W/L est compris entre 1,25 fois et 7,2 fois.

3. Procédé de fabrication de la cellule solaire à couche mince intégrée selon la revendication 1 ou la revendication 2, où une longueur maximale d telle que les cuvettes adjacentes se chevauchent dans le sens de la longueur des rainures est comprise entre 6 % et 33 % de L.

4. Procédé de fabrication de la cellule solaire à couche mince intégrée selon l'une des revendications 1 à 3, où une forme plane de chacune des cuvettes est elliptique.

5. Procédé de fabrication de la cellule solaire à couche mince intégrée selon l'une des revendications 1 à 4, où une surface plane de chacune des cuvettes est comprise entre $3\times10^{-10}$ m$^2$ et $4\times10^{-8}$ m$^2$.

6. Procédé de fabrication de la cellule solaire à couche mince intégrée selon l'une des revendications 1 à 5, comprenant :

une étape de rayonnement d'un premier faisceau laser sur toute la zone pour former une pluralité de rainures de séparation (9040) de couche d'électrode arrière ; et
une étape de rayonnement additionnel d'un deuxième faisceau laser sur au moins une partie de chacune des rainures d'un nombre fractionnel sélectionné entre toutes les rainures de séparation (9040) de couche d'électrode arrière ;
où le centre d'une zone irradiée (N) est décalé du centre de la zone irradiée (M) dans une direction opposée à la rainure de séparation de couche semi-conductrice la plus proche, de sorte que la zone irradiée (N) du deuxième faisceau laser chevauche partiellement la zone irradiée (M) du premier faisceau laser.

7. Procédé de fabrication de la cellule solaire à couche mince intégrée selon la revendication 6, où un rapport entre une valeur locale maximale de la largeur de rainure dans une partie formée par rayonnement additionnel du deuxième faisceau laser et une valeur locale maximale de la largeur de rainure dans une partie formée par rayonnement unique du premier faisceau laser est compris entre 1,15 et 1,8 dans les rainures de séparation (9040) de couche d'électrode arrière.

8. Procédé de fabrication de la cellule solaire à couche mince intégrée selon la revendication 6 ou la revendication 7, où la densité d'énergie du deuxième faisceau laser est faible en comparaison du premier faisceau laser.

9. Procédé de fabrication de la cellule solaire à couche mince intégrée selon l'une des revendications 6 à 8, où le premier et le deuxième faisceaux laser sont rayonnés dans un état pulsé, et le nombre de pulsations irradiées du deuxième faisceau laser est élevé en comparaison du premier faisceau laser relativement à une unité de longueur des rainures de séparation (9040) de couche d'électrode arrière.

10. Procédé de fabrication de la cellule solaire à couche mince intégrée selon l'une des revendications 1 à 5, où :

au moins une partie de chacune des rainures d'un nombre fractionnel entre les rainures d'une pluralité de rainures de séparation (9040) de couche d'électrode arrière est composée d'une rangée de cuvettes d'un premier type (9044) de forme identique ayant un premier pas et d'une rangée de cuvettes d'un deuxième type (9046) de forme identique ayant un deuxième pas ;
la rangée de cuvettes d'un premier type et la rangée de cuvettes d'un deuxième type se chevauchent partiellement dans le sens de la largeur de la rainure ;
une longueur locale maximale (Wn) de la rangée de cuvettes d'un deuxième type dans le sens de la largeur de la rainure est peu élevée en comparaison d'une longueur locale maximale (Wm) de la rangée de cuvettes d'un premier type dans le sens de la largeur de la rainure ; et
une ligne centrale de la rangée de cuvettes d'un deuxième type est décalée d'une ligne centrale de la rangée de cuvettes d'un premier type dans une direction opposée à la rainure de séparation de couche semi-conductrice la plus proche.

11. Procédé de fabrication de la cellule solaire à couche mince intégrée selon la revendication 10, où un rapport (Wo/Wm) entre une longueur locale maximale (Wo) de la largeur de rainure composée de la rangée de cuvettes d'un premier type et de la rangée de cuvettes d'un deuxième type et une longueur locale maximale (Wm) de la rangée de cuvettes d'un premier type dans le sens de la largeur de la rainure est compris entre 1,15 et 1,8.

12. Procédé de fabrication de la cellule solaire à couche mince intégrée selon la revendication 10 ou la revendication 11, où le deuxième pas de la rangée de cuvettes d'un deuxième type est peu élevé en comparaison du premier pas de la rangée de cuvettes d'un premier type.

Fig.1

Fig.2

Fig.3

Fig.4

Fig.5

Fig.6

Fig.7

Fig.8

100 μm

Fig.9

100 $\mu$ m

Fig.10

100 μm

Fig.11

Fig.12

Fig.13

Fig.14

Fig.15

Fig.16

Fig.17

903     905     904

9031    9051    9041

Fig.18

100 μm

Fig.19

100 μ m

Fig.20

Fig.21

Fig.22

Fig.23

10 μm

Fig.24

10 μm

Fig.25

Fig.26

Fig.27

**EP 2 169 724 B1**

## REFERENCES CITED IN THE DESCRIPTION

### Patent documents cited in the description

- JP 2002033495 A

- JP 2001274446 A